# EUROPEAN PATENT APPLICATION

(11) **EP 1 892 575 A1**
(43) Date of publication of application: **27.02.2008**
(21) Application number: 07016536.0
(22) Date of filing: 23.08.2007
(51) Int. Cl.: G03F 7/039, G03F 7/004

(54) **Positive resist composition and pattern forming method using the same**

(30) Priority: 25.08.2006 JP 2006229201
(71) Applicant: FUJIFILM Corporation, Minato-ku Tokyo (JP)
(72) Inventor: Nishiyama, Fumiyuki, Haibara-gun, Shizuoka (JP); Mizutani, Kazuyoshi, Haibara-gun, Shizuoka (JP); Makino, Masaomi, Haibara-gun, Shizuoka (JP)
(74) Representative: HOFFMANN EITLE

(57) **Abstract**

A positive resist composition comprising: (A) a resin having a repeating unit represented by a specific formula (I) and a repeating unit represented by a specific formula (A1); (B) a compound capable of generating an acid upon irradiation with an actinic ray or radiation; and (F) a surfactant represented by a specific formula (II); and a pattern forming method using the same.

## Description

### Background of the Invention

### 1. Field of the Invention

The present invention relates to a positive resist composition suitable for use in the ultramicrolithography process such as production of VLSI or a high-capacity microchip or in other photofabrication processes, and a pattern forming method using the same. More specifically, the present invention relates to a positive resist composition capable of forming a high-resolution pattern by using KrF excimer laser light, electron beam, EUV light or the like, and a pattern forming method using the same. That is, the present invention relates to a positive resist composition suitably usable for fine processing of a semiconductor device, where KrF excimer laser light, electron beam or EUV light is used, and a pattern forming method using the same.

### 2. Description of the Related Art

In the process of producing a semiconductor device such as IC and LSI, fine processing by lithography using a photoresist composition has been conventionally performed. Recently, the integration degree of an integrated circuit is becoming higher and formation of an ultrafine pattern in the sub-micron or quarter-micron region is required. To cope with this requirement, the exposure wavelength also tends to become shorter, for example, from g line to i line or further to KrF excimer laser light. At present, other than the excimer laser light, development of lithography using electron beam, X ray or EUV light is proceeding.

As regards the resist suitable for such a lithography process using KrF excimer laser light, electron beam, X ray or EUV light, a chemical amplification-type resist utilizing an acid catalytic reaction is mainly used from the standpoint of elevating the sensitivity and in the case of a positive resist, a chemical amplification-type resist composition mainly comprising an acid generator and a phenolic polymer which is insoluble or sparingly soluble in an alkali developer but becomes soluble in an alkali developer under the action of an acid (hereinafter simply referred to as a "phenolic acid-decomposable resin"), is being effectively used.

With respect to such a positive resist, there are known some resist compositions using a phenolic acid-decomposable resin obtained by copolymerizing an acid-decomposable acrylate monomer having an alicyclic group as the acid-decomposable group. Examples thereof include the positive resist compositions disclosed in U.S. Patent 5,561,194, JP-A-2001-166474, JP-A-2001-166478, JP-A-2003-107708 and JP-A-2001-194792.

In U.S. Patent 6,312,870, a resist comprising a resin containing a repeating unit derived from a cinnamic acid ester is disclosed with an attempt to improve the pattern profile and the etching resistance.

However, the conventional resist compositions are demanded to be more improved in view of performance against development defects which are generated after development.

### Summary of the Invention

An object of the present invention is to solve the problems in the technology for enhancing the performance at the fine processing of a semiconductor device using an actinic ray or radiation, particularly, KrF excimer laser light, electron beam or EUV light, and provide a positive resist composition improved in the performance against development defects and a pattern forming method using the same.

The present invention has been attained by the following constructions.
(1) A positive resist composition comprising: (A) a resin having a repeating unit represented by formula (I) and a repeating unit represented by formula (A1); (B) a compound capable of generating an acid upon irradiation with an actinic ray or radiation; and (F) a surfactant represented by formula (II): 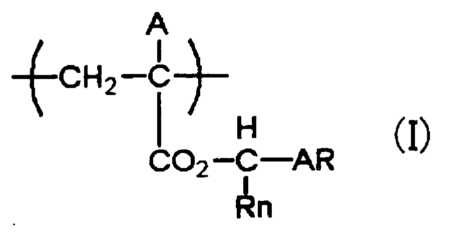 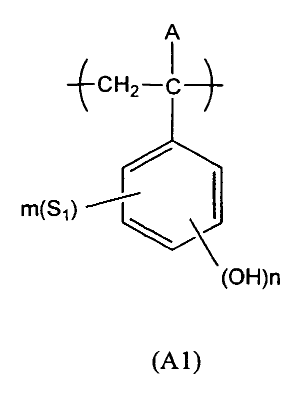 wherein A represents a hydrogen atom, an alkyl group, a halogen atom, a cyano group or an alkyloxycarbonyl group,
   AR represents a benzene ring or a naphthalene ring,
   Rn represents an alkyl group, a cycloalkyl group or an aryl group,
   S₁ represents a substituent, and when a plurality of S₁s are present, S₁s each independently represents a substituent,
   m represents an integer of 0 to 3, and
   n represents an integer of 0 to 3, provided that m+n≤5; 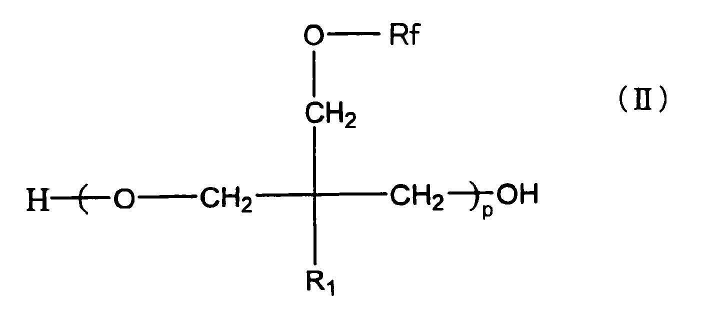 wherein Rf represents a fluoroalkyl group,
   R₁ represents a hydrogen atom or an alkyl group, and
   p represents an integer of 1 to 30.
(2) The positive resist composition as described in (1), wherein the repeating unit represented by formula (A1) is at least one kind of a repeating unit selected from a repeating unit selected from the group consisting of a repeating unit represented by formula (Al-1) and a repeating unit represented by formula (A1-2): 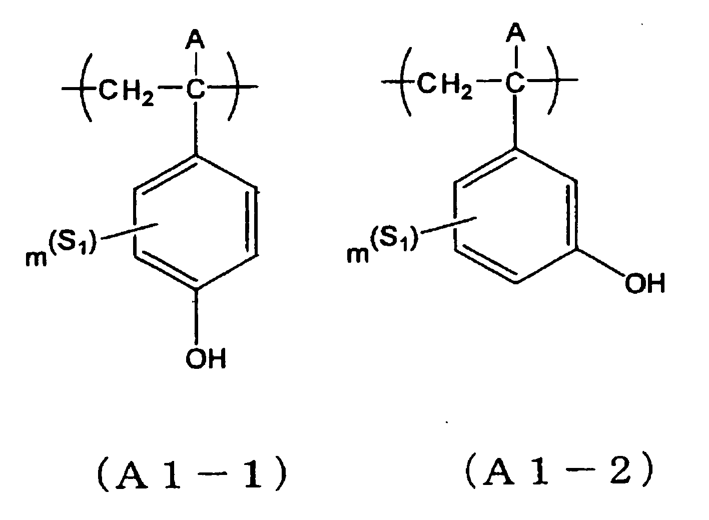 wherein A represents a hydrogen atom, an alkyl group, a halogen atom, a cyano group or an alkyloxycarbonyl group,
   S₁ represents a substituent, and when a plurality of S₁s are present, S₁s each independently represents a substituent, and
   m represents an integer of 0 to 3.
(3) The positive resist composition as described in (1) or (2), wherein an amount of the surfactant (F) is from 0.01 to 0.7 mass% based on the entire mass of the positive resist composition excluding the solvent.
(4) The positive resist composition as described in any one of (1) to (3), wherein the resin (A) further has a repeating unit represented by formula (A2): 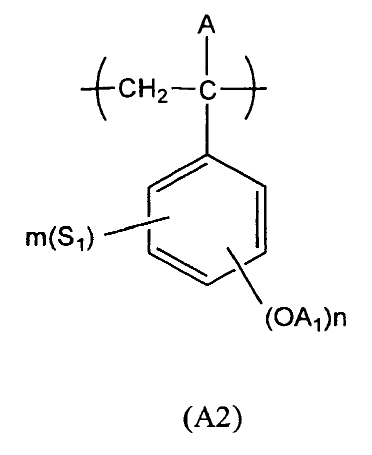 wherein A represents a hydrogen atom, an alkyl group, a halogen atom, a cyano group or an alkyloxycarbonyl group,
   S₁ represents a substituent, and when a plurality of S₁s are present, S₁s each independently represents a substituent,
   A₁ represents a group which desorbs under the action of an acid, or a group having an acid-decomposable group,
   m represents an integer of 0 to 3, and
   n represents an integer of 0 to 3, provided that m+n≤5.
(5) A pattern forming method comprising: forming a resist film with the positive resist composition described in any one of (1) to (4), and exposing and developing the resist film.

### Detailed Description of the Invention

The best mode for carrying out the present invention is described below.

Incidentally, in the present invention, when a group (atomic group) is denoted without specifying whether substituted or unsubstituted, the group includes both a group having no substituent and a group having a substituent. For example, an "alkyl group" includes not only an alkyl group having no substituent (unsubstituted alkyl group) but also an alkyl group having a substituent (substituted alkyl group).

### [1] (A) Resin having a repeating unit represented by formula (I) and a repeating unit represented by formula (A1)

The positive resist composition of the present invention comprises a resin having a repeating unit represented by the following formula (I) and a repeating unit represented by the following formula (A1) (sometimes called "a resin as the component (A)" or "a resin (A)").

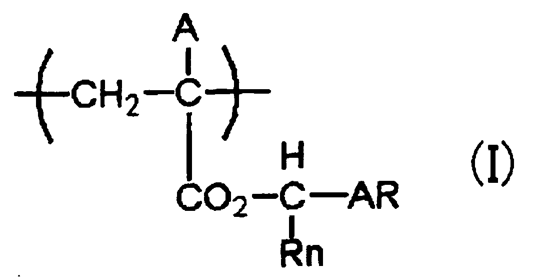

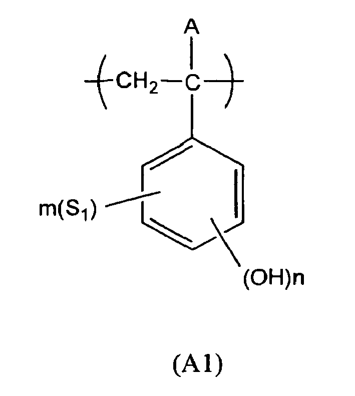

In formulae (I) and (A1),
A represents a hydrogen atom, an alkyl group, a halogen atom, a cyano group or an alkyloxycarbonyl group,
AR represents a benzene ring or a naphthalene ring,
Rn represents an alkyl group, a cycloalkyl group or an aryl group,
S₁ represents a substituent, and when a plurality of S₁S are present, S₁S each independently represents a substituent,
m represents an integer of 0 to 3, and
n represents an integer of 0 to 3, provided that m+n≤5.

The alkyl group of A in formula (I) includes a linear alkyl group preferably having a carbon number of 1 to 5, such as methyl group, ethyl group, propyl group, isopropyl group, n-butyl group, isobutyl group and tert-butyl group. This alkyl group may have a substituent, and preferred examples of the substituent which the alkyl group may have include a hydroxyl group and a halogen atom.

The halogen atom of A includes a fluorine atom, a chlorine atom, a bromine atom and an iodine atom, with a fluorine atom being preferred.

Examples of the alkyl contained in the alkyloxycarbonyl group of A are the same as those of the alkyl group above.

A is preferably a hydrogen atom, a methyl group or a trifluoromethyl group.

The benzene ring and naphthalene ring of AR each may have a substituent, and preferred examples of the substituent which such a ring may have include an alkyl group, an alkoxy group, a hydroxyl group, a halogen atom, a nitro group, a cyano group, an acyl group, an acyloxy group, an aryl group, an aryloxy group and an aralkyl group. The alkyl group, the alkoxy group and the like may further have a substituent such as halogen atom. Also, a ring structure (preferably a 5- or 6-membered ring) containing two adjacent carbon atoms on the benzene or naphthalene ring may be formed, and a heteroatom such as oxygen atom may be contained in the ring structure.

The alkyl group of Rn includes a linear or branched alkyl group preferably having a carbon number of 1 to 20, such as methyl group, ethyl group, propyl group, isopropyl group, n-butyl group, isobutyl group, tert-butyl group, pentyl group, hexyl group, octyl group and dodecyl group.

The cycloalkyl group of Rn is preferably a cycloalkyl group having a carbon number of 3 to 8, and examples thereof include a cyclopropyl group, a cyclobutyl group, a cyclopentyl group, a cyclohexyl group and a cyclooctyl group.

The aryl group of Rn is preferably an aryl group having a carbon number of 6 to 14, such as phenyl group, xylyl group, toluyl group, cumenyl group, naphthyl group and anthracenyl group.

These groups each may have a substituent, and preferred examples of the substituent which such a group may have include an alkyl group, an alkoxy group, an alkoxycarbonyl group, an aryl group, a hydroxyl group, a halogen atom, an amino group, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group and a heterocyclic residue such as pyrrolidone residue. Among these, an alkyl group, an alkoxy group, an alkoxycarbonyl group, a hydroxyl group, a halogen atom, an amino group, a nitro group, an acyl group, an acyloxy group, an acylamino group and a sulfonylamino group are more preferred.

The repeating unit represented by formula (I) decomposes under the action of an acid and generates a carboxyl group, whereby the solubility in an alkali developer is increased.

That is, the resin (A) is an acid-decomposable resin of which solubility in an alkali developer increases under the action of an acid.

Specific examples of the repeating unit represented by formula (I) are set forth below, but the present invention is not limited thereto.

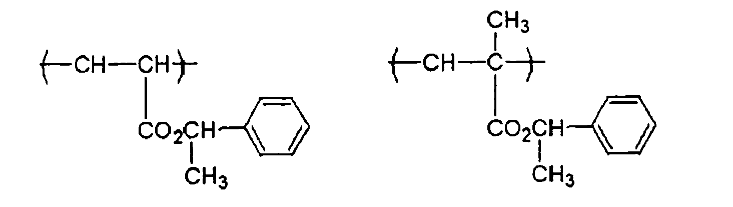

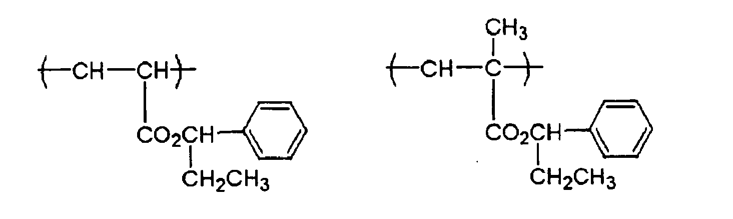

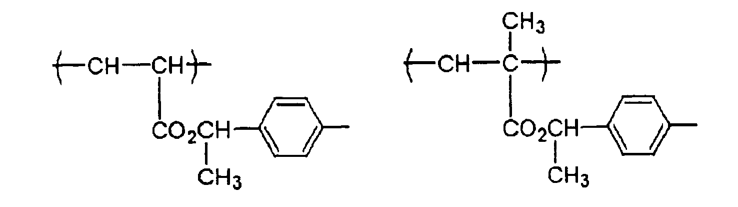

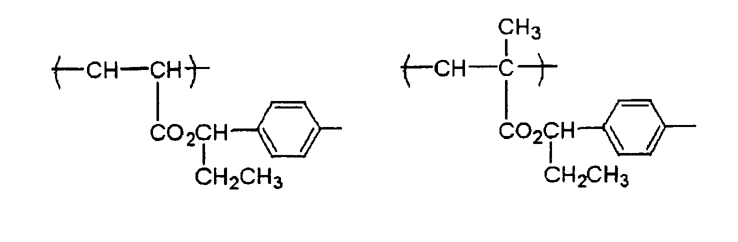

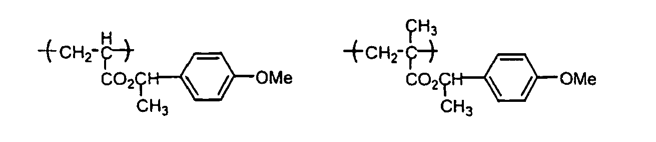

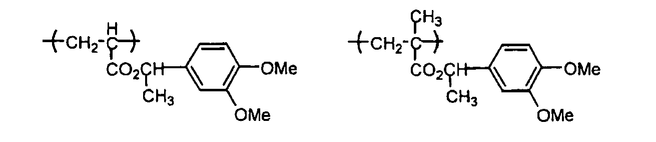

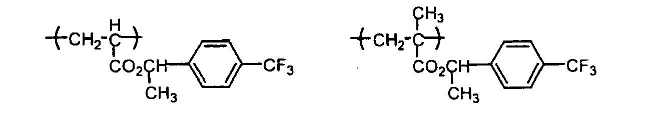

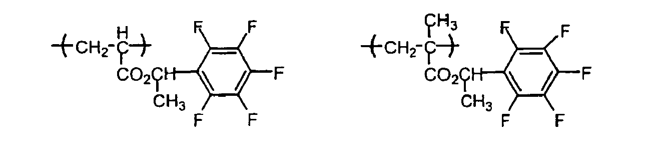

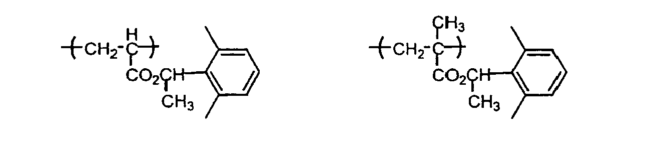

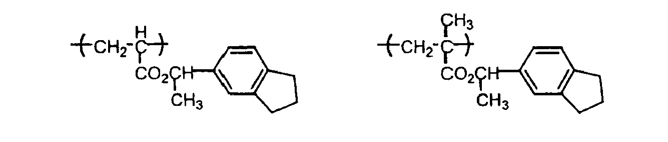

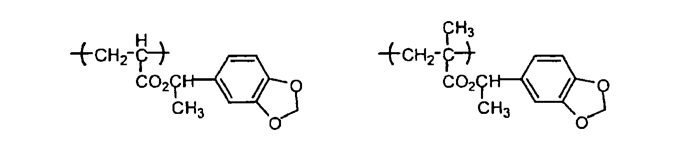

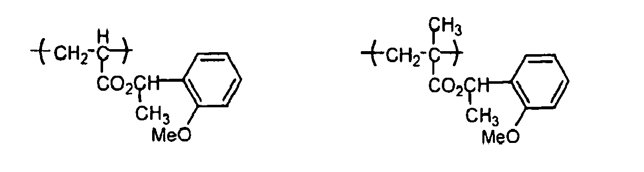

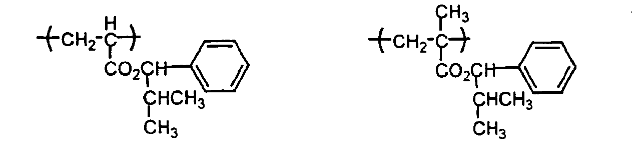

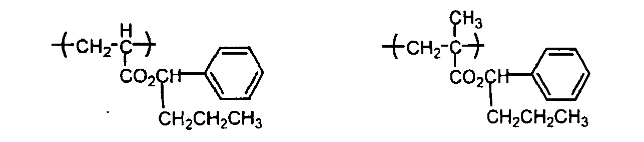

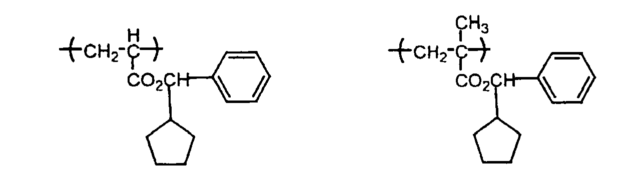

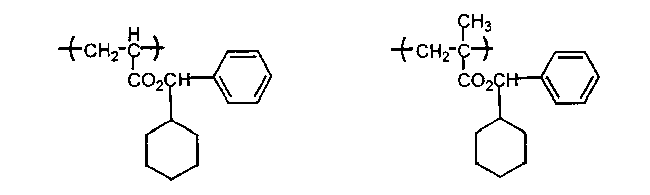

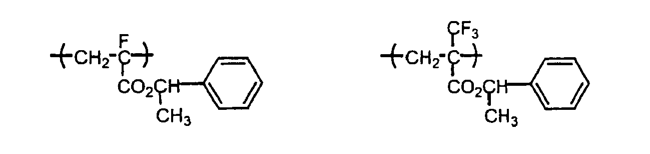

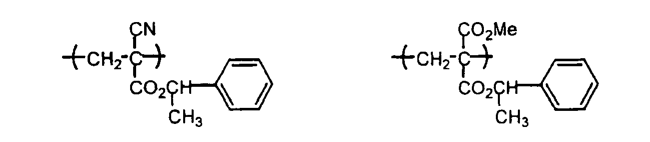

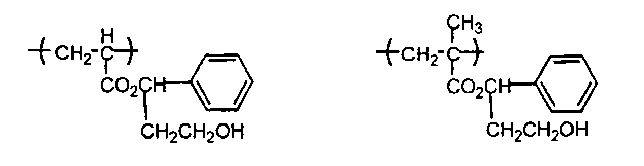

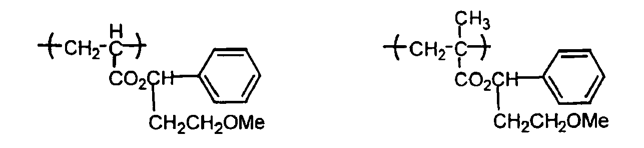

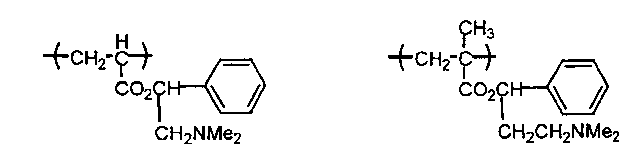

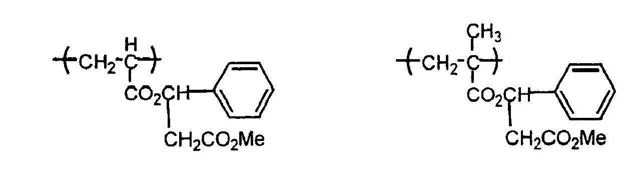

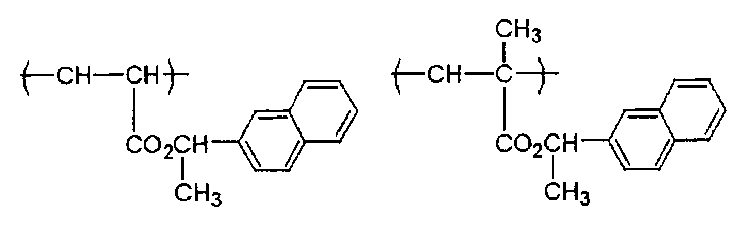

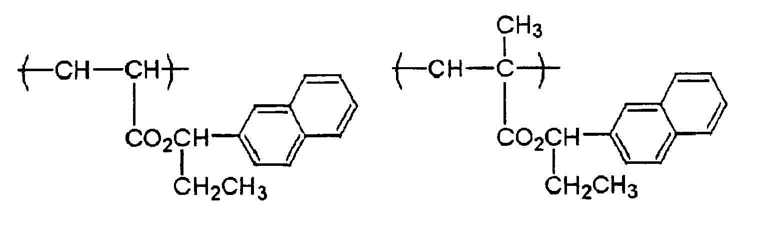

In formula (A1), A has the same meaning as A in formula (I).

Examples of the substituent of S₁ include an alkyl group, an alkoxy group, an alkoxycarbonyl group, an acyl group, an acyloxy group, a halogen atom, a cyano group, a nitro group, a sulfonylamino group, an aryl group, an aryloxy group, an aralkyl group, an alkylthio group, an arylthio group and an alkylthio group.

The repeating unit represented by formula (A1) is preferably at least one kind of a repeating unit selected from a repeating unit represented by the following formula (A1-1) and a repeating unit represented by the following formula (A1-2).

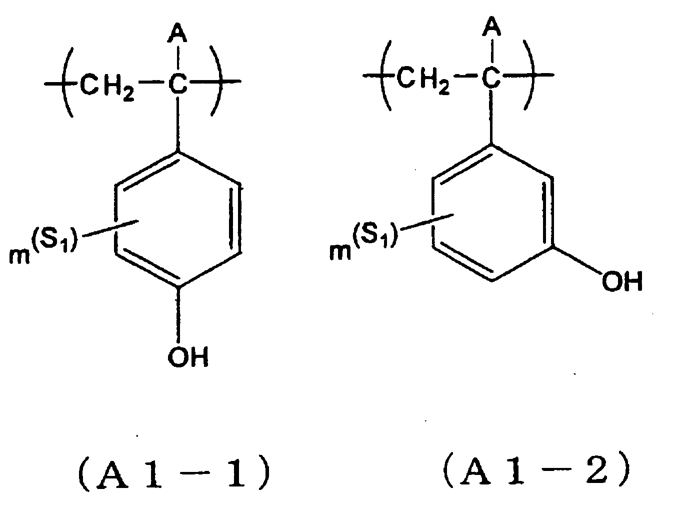

In formulae (A1-1) and (A1-2),
A represents a hydrogen atom, an alkyl group, a halogen atom, a cyano group or an alkyloxycarbonyl group,
S₁ represents a substituent, and when a plurality of S₁s are present, S₁ each independently represents a substituent, and
m represents an integer of 0 to 3.

In formulae (A1-1) and (A1-2), A, S₁ and m have the same meanings as A, S₁ and m in formula (A1).

Specific examples of the repeating unit represented by formula (A1) are set forth below, but the present invention is not limited thereto.

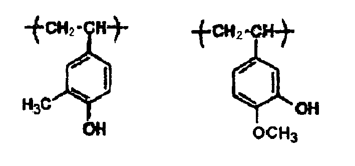

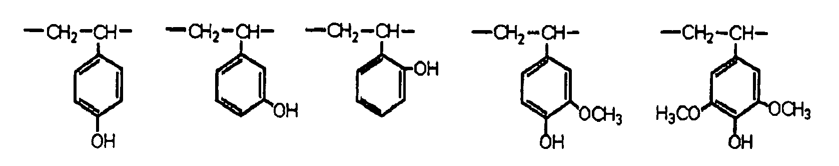

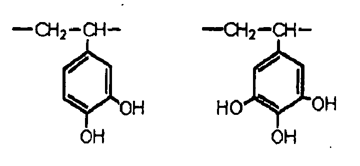

The resin (A) preferably further has a repeating unit represented by the following formula (A2).

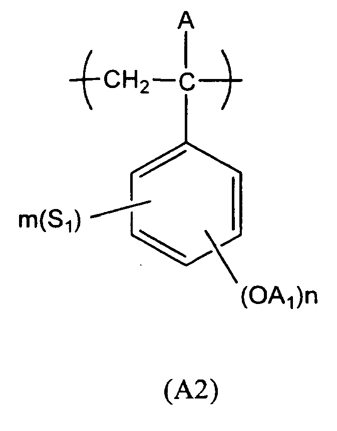

In formula (A2),
A represents a hydrogen atom, an alkyl group, a halogen atom, a cyano group or an alkyloxycarbonyl group,
S₁ represents a substituent, and when a plurality of S₁s are present, S₁s each independently represents a substituent,
A₁ represents a group which desorbs under the action of an acid, or a group having an acid-decomposable group,
m represents an integer of 0 to 3, and
n represents an integer of 0 to 3,
provided that m+n≤5.

In formula (A2), A, S₁, m and n have the same meanings as A, S₁, m and n in formula (A1).

Specific examples of the group of A₁, which desorbs under the action of an acid, include a tertiary alkyl group such as tert-butyl group and tert-amyl group, a tert-butoxycarbonyl group, a tert-butoxycarbonylmethyl group, and an acetal group represented by -C(L₁)(L₂)-O-Z.
L₁ and L₂, which may be the same or different, each represents a hydrogen atom, an alkyl group, a cycloalkyl group, an aryl group or an aralkyl group.
Z represents an alkyl group, a cycloalkyl group, an aryl group or an aralkyl group.
Z and L₁ may combine with each other to form a 5- or 6-membered ring.

The alkyl group of L₁, L₂ and Z is preferably an alkyl group having a carbon number of 1 to 8, and examples thereof include a methyl group, an ethyl group, a propyl group, an n-butyl group, a sec-butyl group, a hexyl group and an octyl group.

The cycloalkyl group of L₁, L₂ and Z may be either monocyclic or polycyclic. The monocyclic cycloalkyl group is preferably a cycloalkyl group having a carbon number of 3 to 8, and examples thereof include a cyclopropyl group, a cyclobutyl group, a cyclopentyl group, a cyclohexyl group and a cyclooctyl group. The polycyclic cycloalkyl group is preferably a cycloalkyl group having a carbon number of 6 to 20, and examples thereof include an adamantyl group, a norbornyl group, an isobornyl group, a camphanyl group, a dicyclopentyl group, an α-pinel group, a tricyclodecanyl group, a tetracyclododecyl group and an androstanyl group. Incidentally, the carbon atoms in the cycloalkyl group may be partially substituted by a heteroatom such as oxygen atom.

The aryl group of L₁, L₂ and Z is preferably an aryl group having a carbon number of 6 to 10, and examples thereof include a phenyl group, a naphthyl group and an anthryl group.

The aralkyl group of L₁, L₂ and Z is preferably an aralkyl group having a carbon number of 7 to 12, and examples thereof include a benzyl group, a phenethyl group and a naphthylmethyl group.

L₁, L₂ and Z each may have a substituent. Examples of the substituent which L₁, L₂ and Z each may have include an alkyl group, a cycloalkyl group, an aryl group, an amino group, an amido group, a ureido group, a urethane group, a hydroxyl group, a carboxyl group, a halogen atom, an alkoxy group, a thioether group, an acyl group, an acyloxy group, an alkoxycarbonyl group, a cyano group and a nitro group.

Examples of the 5- or 6-membered ring formed after Z and L₁ combine with each other include a tetrahydropyran ring and a tetrahydrofuran ring..

Examples of the group having an acid-decomposable group of A₁ include an alkyl group (preferably having a carbon number of 1 to 5) having an acid-decomposable group.

Examples of the acid-decomposable group include a group where the hydrogen atom of an alkali-soluble group such as carboxyl group, phenolic hydroxyl group, sulfonic acid group and thiol group is protected by a group which desorbs under the action of an acid.

Examples of the group which desorbs under the action of an acid include - C(R₃₆)(R₃₇)(R₃₈), -C(R₃₆)(R₃₇)(OR₃₉), -C(=O)-O-C(R₃₆)(R₃₇)(R₃₈), -C(R₀₁)(R₀₂)(OR₃₉) and -C(R₀₁ )(R₀₂)-C(=O)-O-C(R₃₆)(R₃₇)(R₃₈).

In the formulae, R₃₆ to R₃₉ each independently represents an alkyl group, a cycloalkyl group, an aryl group or an aralkyl group. R₃₆ and R₃₇ may combine with each other to form a ring.

R₀₁ and R₀₂ each independently represents a hydrogen atom, an alkyl group, a cycloalkyl group, an aryl group or an aralkyl group.

Examples of the alkyl group, cycloalkyl group, aryl group and aralkyl group in R₃₆ to R₃₉, R₀₁ and R₀₂ are the same as those of the alkyl group, cycloalkyl group, aryl group and aralkyl group in L₁, L₂ and Z.

In the present invention, Z is preferably a linear or branched alkyl group. By virtue of this, the effect of the present invention is more remarkably exerted.

Specific examples of the repeating unit represented by formula (A2) are set forth below, but the present invention is not limited thereto.

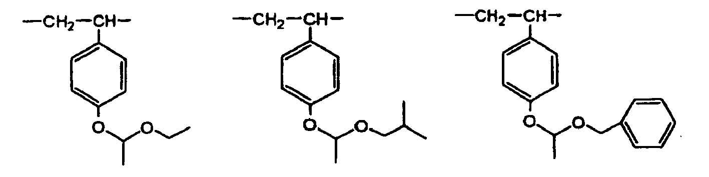

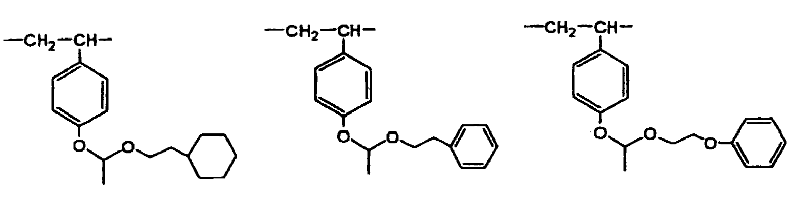

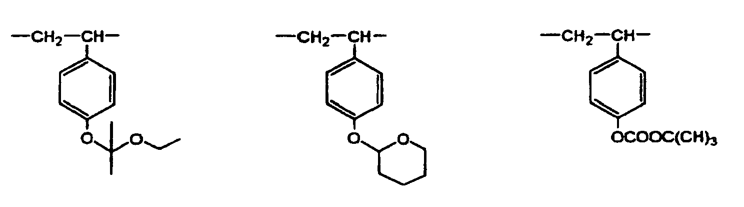

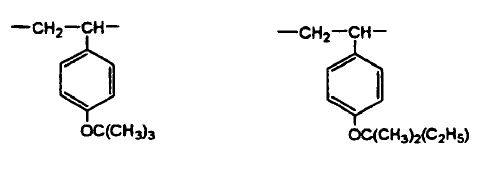

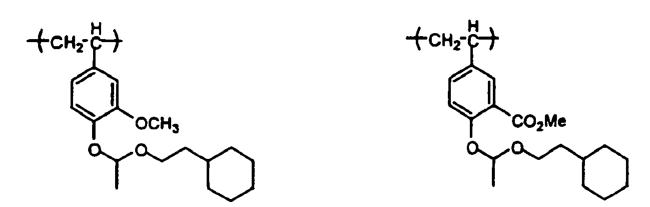

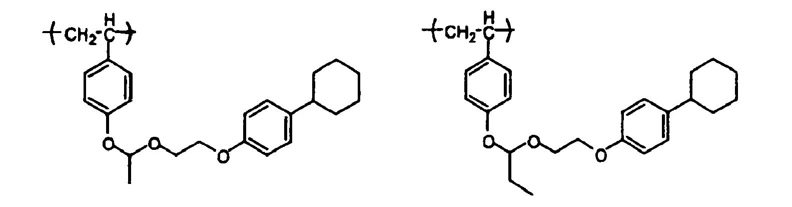

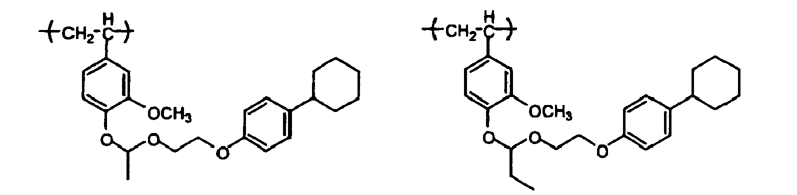

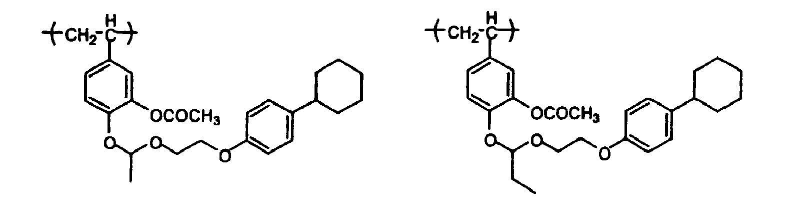

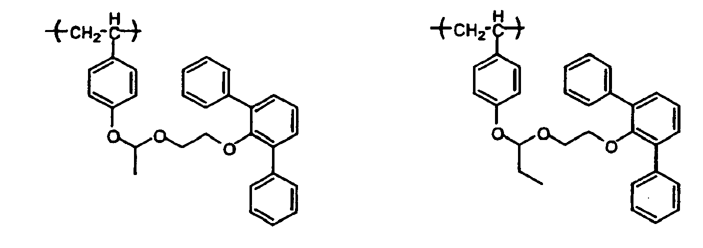

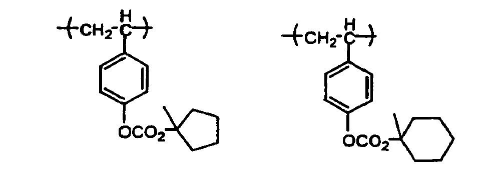

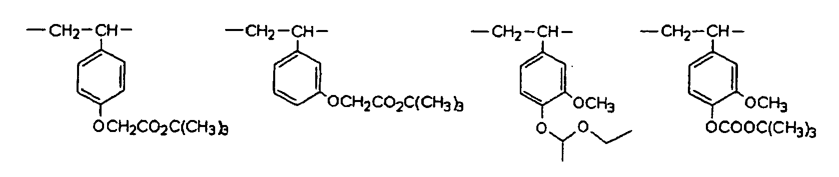

The resin (A) preferably further contains a repeating unit represented by the following formula (A3):

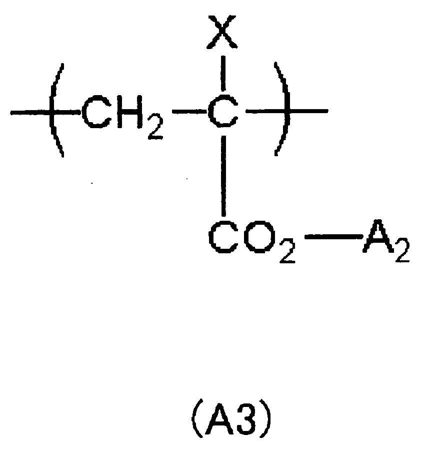

In formula (A3),
X represents a hydrogen atom, an alkyl group, a halogen atom, a cyano group or an alkyloxycarbonyl group,
A₂ represents a group which desorbs under the action of an acid, or a group containing an acid-decomposable group.

In formula (A3), X has the same meaning as A in formula (I).

A₂ is preferably a hydrocarbon group (preferably having a carbon number of 20 or less, more preferably from 4 to 12), more preferably a tert-butyl group, a tert-amyl group or an alicyclic structure-containing hydrocarbon group (for example, an alicyclic group itself or a group where an alicyclic group is substituted to an alkyl group).

The alicylcic structure may be either monocyclic or polycyclic. Specific examples thereof include a monocyclo, bicyclo, tricyclo or tetracyclo structure having a carbon number of 5 or more. The carbon number is preferably from 6 to 30, more preferably from 7 to 25. The alicyclic structure-containing hydrocarbon group may have a substituent.

Examples of the alicyclic structure are set forth below.

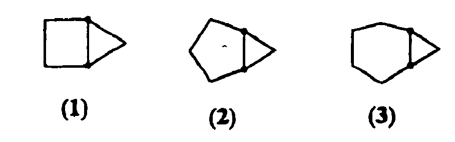

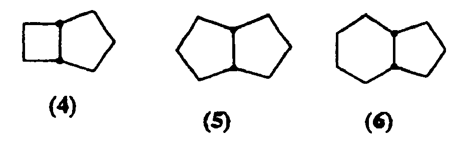

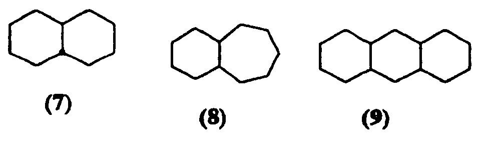

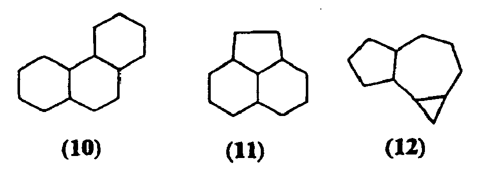

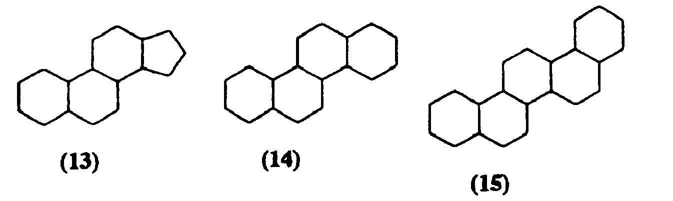

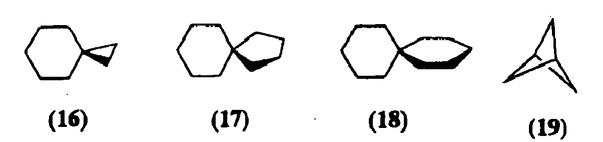

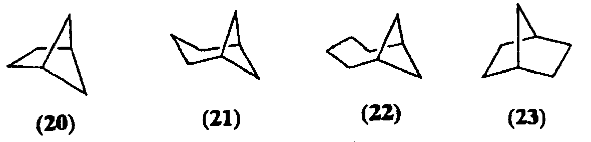

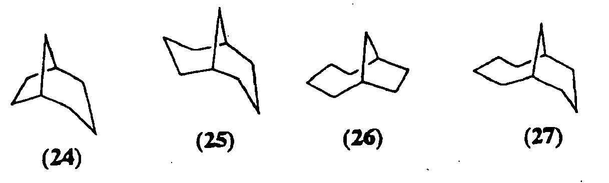

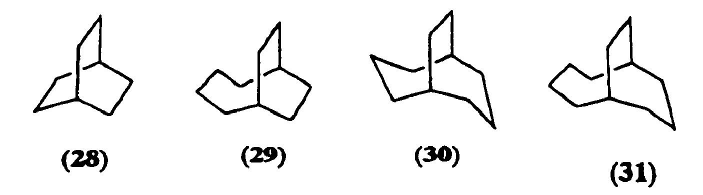

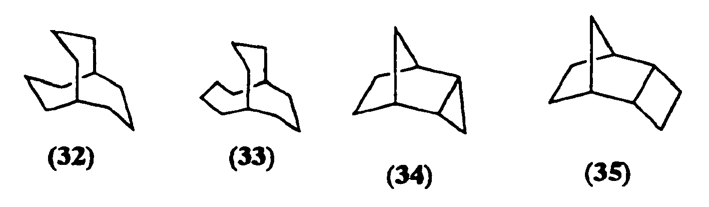

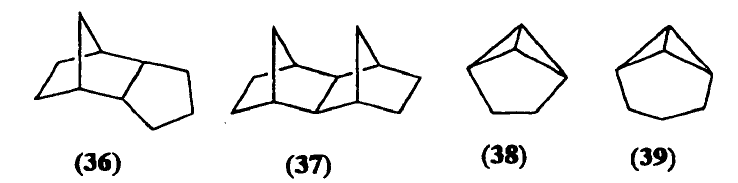

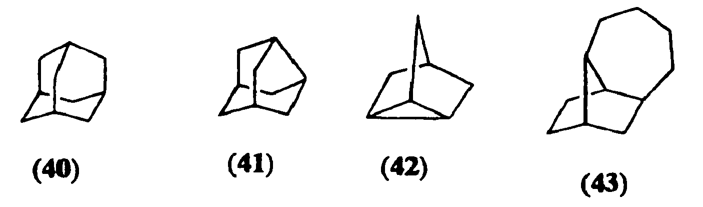

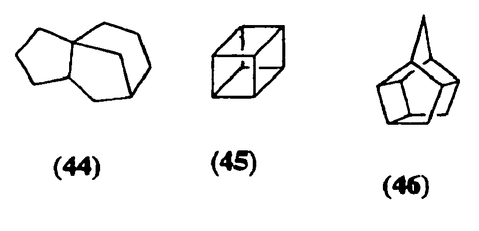

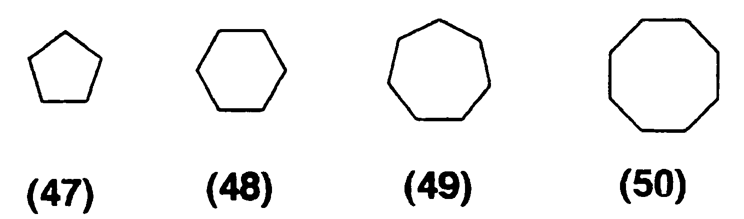

In the present invention, among these alicyclic structures, preferred are, as denoted in terms of the monovalent alicyclic group, an adamantyl group, a noradamantyl group, a decalin residue, a tricyclodecanyl group, a tetracyclododecanyl group, a norbornyl group, a cedrol group, a cyclohexyl group, a cycloheptyl group, a cyclooctyl group, a cyclodecanyl group and a cyclododecanyl group, more preferred are an adamantyl group, a decalin residue, a norbornyl group, a cedrol group, a cyclohexyl group, a cycloheptyl group, a cyclooctyl group, a cyclodecanyl group and a cyclododecanyl group.

Examples of the substituent which the alicyclic ring in these structures may have include an alkyl group, a halogen atom, a hydroxyl group, an alkoxy group, a carboxyl group and an alkoxycarbonyl group. The alkyl group is preferably a lower alkyl group such as methyl group, ethyl group, propyl group, isopropyl group and butyl group, more preferably a methyl group, an ethyl group, a propyl group or an isopropyl group. The alkoxy group includes an alkoxy group having a carbon number of 1 to 4, such as methoxy group, ethoxy group, propoxy group and butoxy group. The alkyl group and the alkoxy group each may further have a substituent, and examples of the substituent which the alkyl group and alkoxy group may further have include a hydroxyl group, a halogen atom and an alkoxy group.

The alicyclic structure-containing group which desorbs under the action of an acid is preferably a group represented by any one of the following formulae (pI) to (pV):

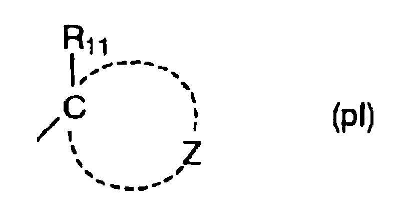

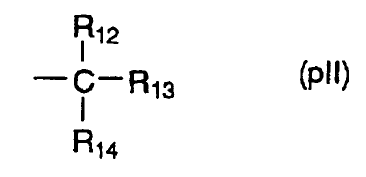

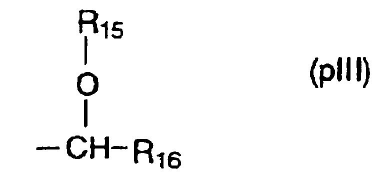

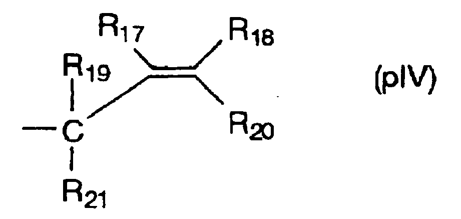

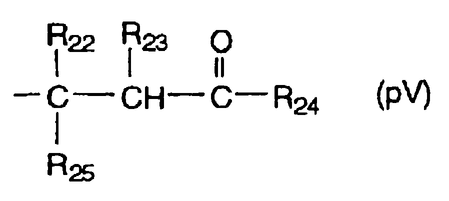

In formulae (pI) to (pV), R₁₁ represents a methyl group, an ethyl group, an n-propyl group, an isopropyl group, an n-butyl group, an isobutyl group or a sec-butyl group.

Z represents an atomic group necessary for forming an alicyclic hydrocarbon group together with the carbon atom.

R₁₂ to R₁₆ each independently represents a linear or branched alkyl group having a carbon number of 1 to 4 or an alicyclic hydrocarbon group, provided that at least one of R₁₂ to R₁₄ or either one of R₁₅ and R₁₆ represents an alicyclic hydrocarbon group.

R₁₇ to R₂₁ each independently represents a hydrogen atom, a linear or branched alkyl group having a carbon number of 1 to 4 or an alicyclic hydrocarbon group, provided that at least one of R₁₇ to R₂₁ represents an alicyclic hydrocarbon group. Also, either one of R₁₉ and R₂₁ represents a linear or branched alkyl group having a carbon number of 1 to 4 or an alicyclic hydrocarbon group.

R₂₂ to R₂₅ each independently represents a hydrogen atom, a linear or branched alkyl group having a carbon number of 1 to 4 or an alicyclic hydrocarbon group, provided that at least one of R₂₂ to R₂₅ represents an alicyclic hydrocarbon group. Also, R₂₃ and R₂₄ may combine with each other to form a ring.

In formulae (pI) to (pV), the alkyl group of R₁₂ to R₂₅ is a linear or branched alkyl group having from 1 to 4 carbon atoms, which may be substituted or unsubstituted, and examples of the alkyl group include a methyl group, an ethyl group, an n-propyl group, an isopropyl group, an n-butyl group, an isobutyl group, a sec-butyl group and a tert-butyl group.

Examples of the substituent which the alkyl group may further have include an alkoxy group having a carbon number of 1 to 4, a halogen atom (e.g., fluorine, chlorine, bromine, iodine), an acyl group, an acyloxy group, a cyano group, a hydroxyl group, a carboxy group, an alkoxycarbonyl group and a nitro group.

Examples of the alicyclic hydrocarbon group of R₁₂ to R₂₅ and the alicyclic hydrocarbon group formed by Z together with the carbon atom include those described above for the alicyclic structure.

Specific examples of the alicyclic structure-containing group which desorbs under the action of an acid, as A₂, are set forth below, but the present invention is not limited thereto.

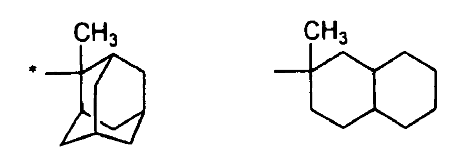

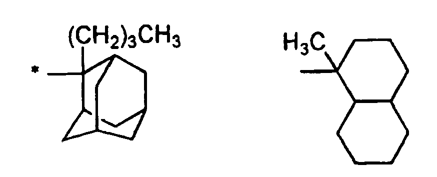

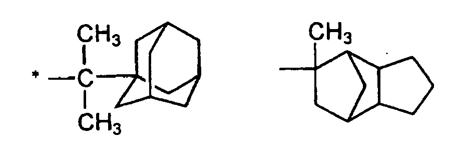

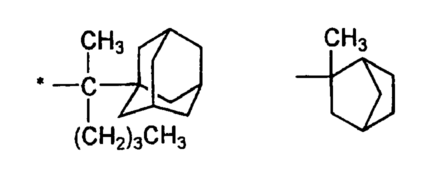

Examples of the acid-decomposable group-containing group of A₂ in formula (A3) are the same as those of the acid-decomposable group-containing group of A1 in formula (A2).

Specific examples of the monomer corresponding to the repeating unit represented by formula (A3) are set forth below, but the present invention is not limited thereto.

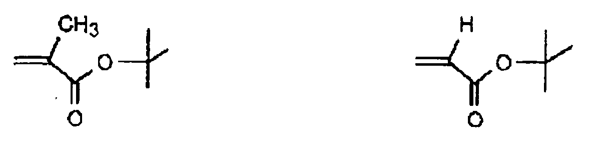

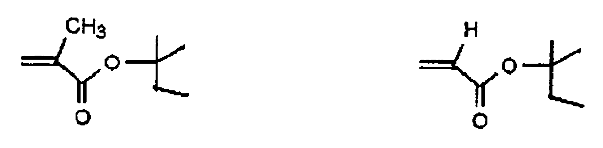

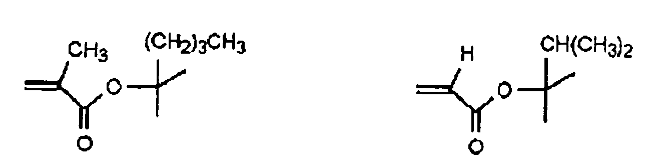

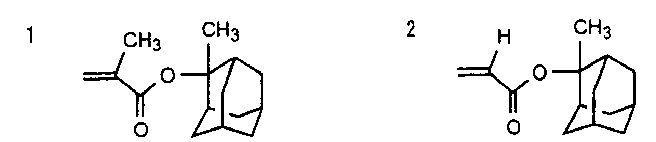

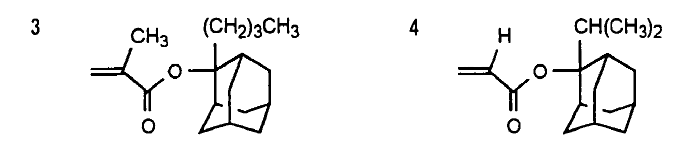

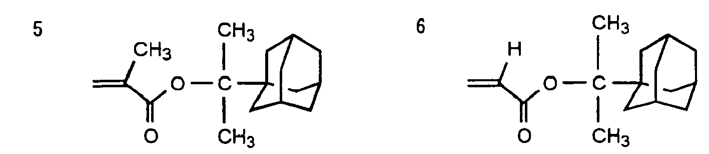

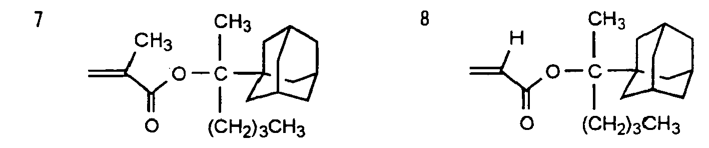

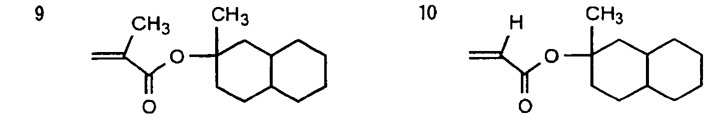

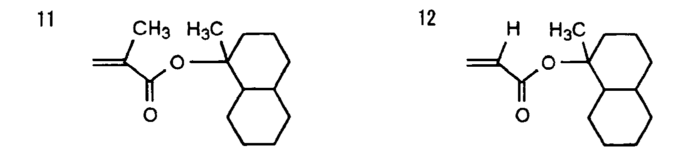

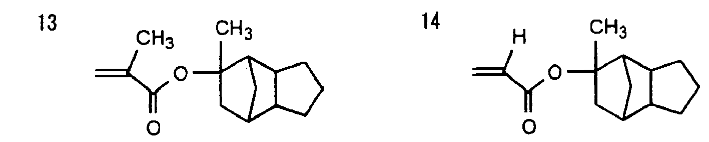

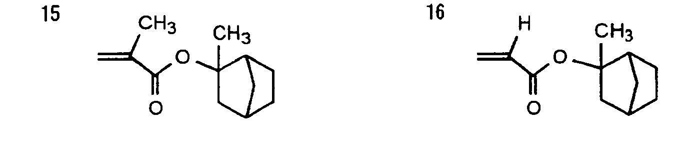

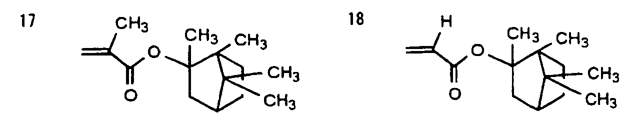

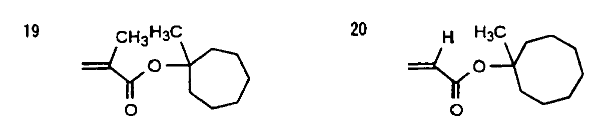

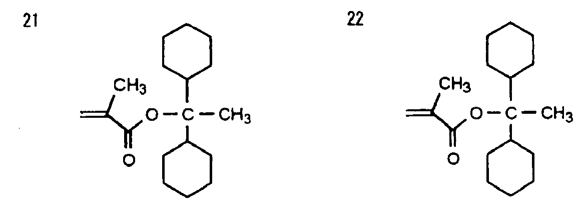

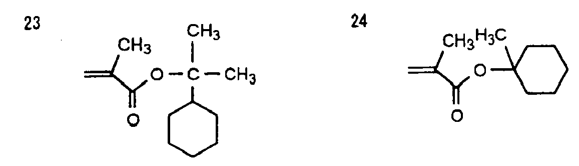

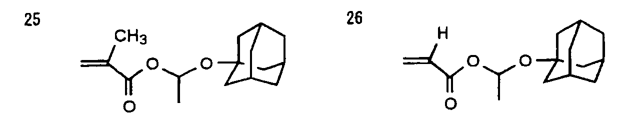

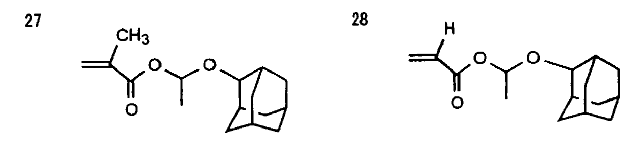

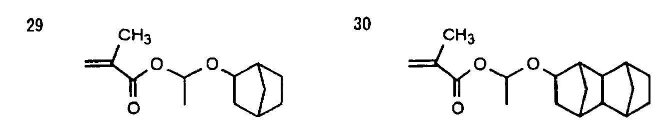

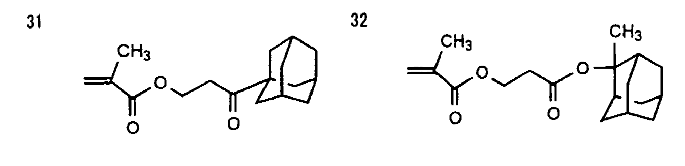

The monomer corresponding to the repeating unit represented by formula (I) or (A3) may be synthesized by esterifying a (meth)acrylic acid chloride and an alcohol compound in a solvent such as THF, acetone and methylene chloride in the presence of a basic catalyst such as triethylamine, pyridine and DBU. A commercially available product may also be used.

The monomer corresponding to the repeating unit represented by formula (A1) or (A2) may be synthesized by acetalizing a hydroxy-substituted styrene monomer and a vinyl ether compound in a solvent such as THF and methylene chloride in the presence of an acidic catalyst such as p-toluenesulfonic acid and pyridine p-toluenesulfonate, or by effecting t-Boc protection using tert-butyl dicarbonate in the presence of a basic catalyst such as triethylamine, pyridine and DBU. A commercially available product may also be used.

The resin (A) preferably further contains a repeating unit represented by the following formula (A4).

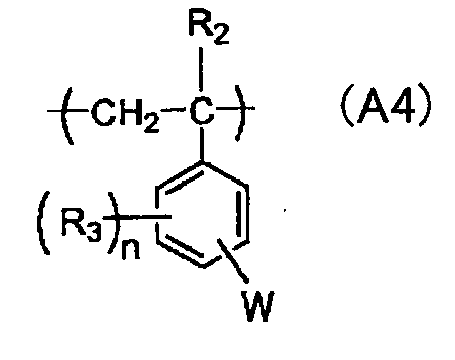

In formula (A4), R₂ represents a hydrogen atom, a methyl group, a cyano group, a halogen atom or a perfluoro group having a carbon number of 1 to 4.

R₃ represents a hydrogen atom, an alkyl group, a halogen atom, an aryl group, an alkoxy group or an acyl group.
n represents an integer of 0 to 4.
W represents a group incapable of decomposing under the action of an acid.

W represents a group incapable of decomposing under the action of an acid (sometimes referred to as an "acid-stable group"), and specific examples thereof include a hydrogen atom, a halogen atom, an alkyl group, a cycloalkyl group, an alkenyl group, an aryl group, an acyl group, an alkylamide group, an arylamidomethyl group and an arylamide group. The acid-stable group is preferably an acyl group or an alkylamide group, more preferably an acyl group, an alkylcarbonyloxy group, an alkyloxy group, a cycloalkyloxy group or an aryloxy group.

In the acid-stable group of W, the alkyl group is preferably an alkyl group having a carbon number of 1 to 4, such as methyl group, ethyl group, propyl group, n-butyl group, sec-butyl group and tert-butyl group; the cycloalkyl group is preferably a cycloalkyl group having a carbon number of 3 to 10, such as cyclopropyl group, cyclobutyl group, cyclohexyl group and adamantyl group; the alkenyl group is preferably an alkenyl group having a carbon number of 2 to 4, such as vinyl group, propenyl group, allyl group and butenyl group; the alkenyl group is preferably an alkenyl group having a carbon number of 2 to 4, such as vinyl group, propenyl group, allyl group and butenyl group; and the aryl group is preferably an aryl group having a carbon number of 6 to 14, such as phenyl group, xylyl group, toluyl group, cumenyl group, naphthyl group and anthracenyl group. W may be present at any position on the benzene ring but is preferably present at the meta-position or para-position, more preferably at the para-position, of the styrene skeleton.

Specific examples of the repeating unit represented by formula (A4) are set forth below, but the present invention is not limited thereto.

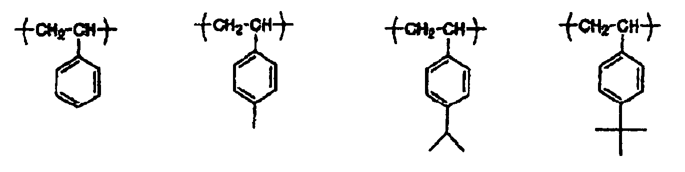

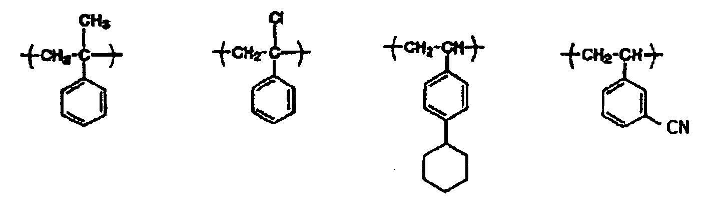

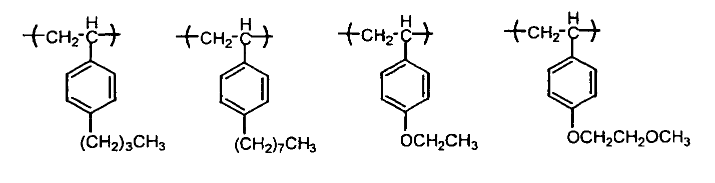

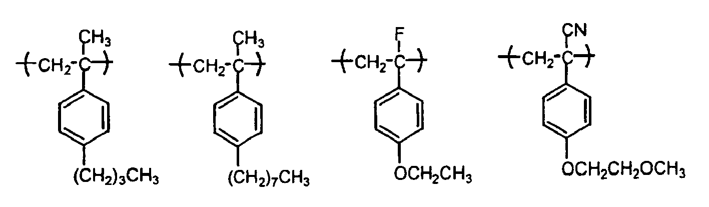

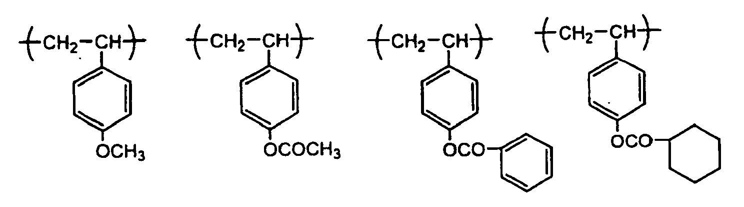

The resin (A) preferably further contains a repeating unit comprising a (meth)acrylic acid derivative incapable of decomposing under the action of an acid.

Specific examples thereof are set forth below, but the present invention is not limited thereto.

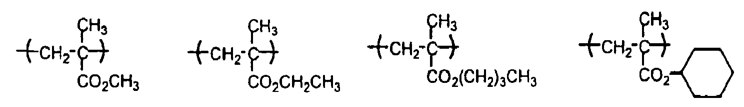

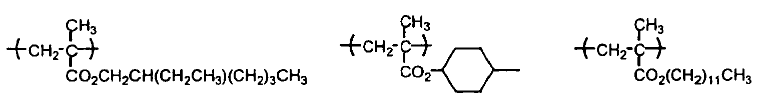

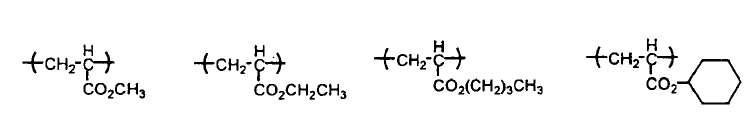

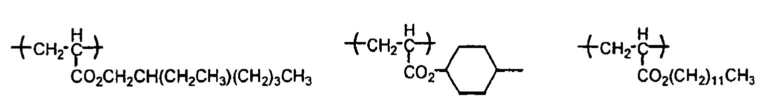

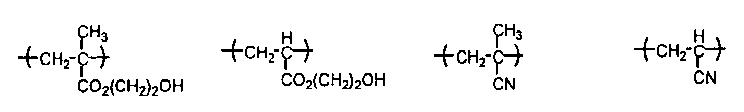

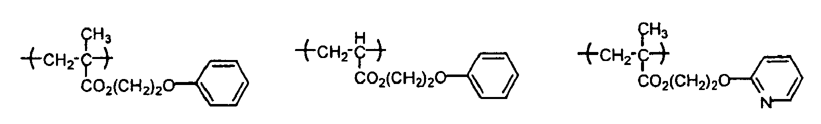

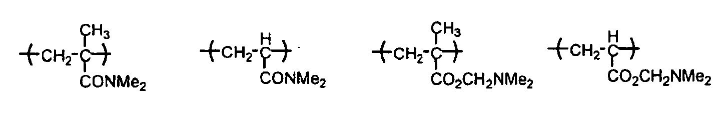

The resin (A) is a resin of which solubility in an alkali developer increases under the action of an acid (acid-decomposable resin), and contains a group capable of decomposing under the action of an acid to increase the solubility in an alkali developer (acid-decomposable group), in an arbitrary repeating unit.

The acid-decomposable group may be contained in the repeating unit represented by formula (I), (A2) or (A3) or in other repeating units.

Examples of the acid-decomposable group include, in addition to those described above, a group represented by -C(=O)-X₁R₀.

In the formula above, R₀ represents, for example, a tertiary alkyl group such as tert-butyl group and tert-amyl group, an isobornyl group, a 1-alkoxyethyl group such as 1-ethoxyethyl group, 1-butoxyethyl group, 1-isobutoxyethyl group and 1-cyclohexyloxyethyl group, an alkoxymethyl group such as 1-methoxymethyl group and 1-ethoxymethyl group, a 3-oxoalkyl group, a tetrahydropyranyl group, a tetrahydrofuranyl group, a trialkylsilyl ester group, a 3-oxocyclohexyl ester group, a 2-methyl-2-adamantyl group or a mevalonic lactone residue. X₁ represents an oxygen atom, a sulfur atom, -NH-, -NHSO₂- or -NHSO₂NH-.

The content of the repeating unit represented by formula (I) in the resin (A) is preferably from 4 to 60 mol%, more preferably from 6 to 50 mol%, still more preferably from 8 to 40 mol%, based on all repeating units.

The content of the repeating unit represented by formula (A1) in the resin (A) is preferably from 40 to 90 mol%, more preferably from 45 to 85 mol%, still more preferably from 50 to 80 mol%, based on all repeating units.

The content of the repeating unit represented by formula (A2) in the resin (A) is preferably from 10 to 60 mol%, more preferably from 10 to 50 mol%, still more preferably from 10 to 40 mol%, based on all repeating units.

The content of the repeating unit represented by formula (A3) in the resin (A) is preferably from 5 to 60 mol%, more preferably from 10 to 50 mol%, still more preferably from 15 to 35 mol%, based on all repeating units.

The resin (A) may further contain a repeating unit represented by formula (4), and this is preferred from the standpoint of, for example, enhancing the film quality or suppressing the film loss in the unexposed area. The content of the repeating unit represented by formula (4) is preferably from 0 to 50 mol%, more preferably from 0 to 40 mol%, still more preferably from 0 to 30 mol%, based on all repeating units.

In the resin (A), other appropriate polymerizable monomers may be copolymerized to introduce an alkali-soluble group such as phenolic hydroxyl group or carboxyl group for maintaining good developability with an alkali developer, or other hydrophobic polymerizable monomers such as alkyl acrylate or alkyl methacrylate may be copolymerized for enhancing the film quality.

The resin (A) can be synthesized by an ordinary method (for example, radical polymerization). Examples of the synthesis method in general include a batch polymerization method of dissolving the monomer species and an initiator in a solvent and heating the solution, thereby effecting the polymerization, and a dropping polymerization method of adding dropwise a solution containing monomer species and an initiator in a heated solvent over 1 to 10 hours. A dropping polymerization method is preferred. Examples of the reaction solvent include tetrahydrofuran, 1,4-dioxane, ethers (e.g., diisopropyl ether), ketones (e.g., methyl ethyl ketone, methyl isobutyl ketone), an ester solvent (e.g., ethyl acetate), an amide solvent (e.g., dimethylformamide, dimethylacetamide), and a solvent capable of dissolving the composition of the present invention, which is described later, such as propylene glycol monomethyl ether acetate, propylene glycol monomethyl ether and cyclohexanone. The polymerization is preferably performed using the same solvent as the solvent used in the positive resist composition of the present invention. By the use of this solvent, generation of particles during storage can be suppressed.

The polymerization reaction is preferably performed in an inert gas atmosphere such as nitrogen or argon. The polymerization is started using a commercially available radical initiator (e.g., azo-based initiator, peroxide). The radical initiator is preferably an azo-based initiator, and an azo-based initiator having an ester group, a cyano group or a carboxyl group is preferred. Preferred examples of the initiator include azobisisobutyronitrile, azobisdimethylvaleronitrile and dimethyl 2,2'-azobis(2-methylpropionate). The initiator is added additionally or in parts, if desired. After the completion of reaction, the reactant is charged into a solvent, and the desired polymer is recovered by a method such as powder or solid recovery. The reaction concentration is from 5 to 50 mass%, preferably from 10 to 30 mass%, and the reaction temperature is usually from 10 to 150°C, preferably from 30 to 120°C, more preferably from 50 to 100°C.

The weight average molecular weight (Mw) of the resin (A) is preferably from 1,000 to 15,000, more preferably from 3,000 to 10,000. The dispersity (Mw/Mn) is preferably from 1.0 to 2.0, more preferably from 1.0 to 1.8, still more preferably from 1.0 to 1.5.

The weight average molecular weight here is defined as a polystyrene-reduced value determined by gel permeation chromatography.

The dispersity can be adjusted by selecting the polymerization method or the purification method of the resin. The resin (A) having a dispersity of 1.5 to 2.0 can be synthesized, for example, by radical polymerization using an azo-based polymerization initiator. Also, the resin (A) having a still more preferred dispersity of 1.0 to 1.5 can be synthesized, for example, by living radical polymerization.

As for the resin (A), two or more kinds may be used in combination.

The amount of the resin (A) added is, as the total amount, usually from 10 to 96 mass%, preferably from 15 to 96 mass%, more preferably from 20 to 95 mass%, based on the entire solid content of the positive resist composition.

Specific examples of the resin as the component (A) are set forth below, but the present invention is not limited thereto.

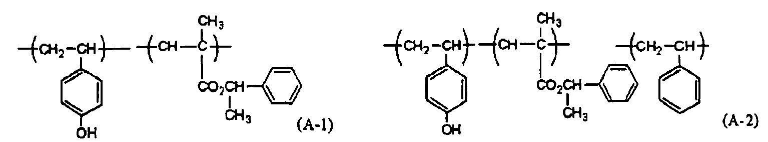

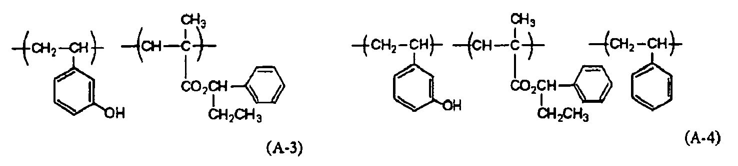

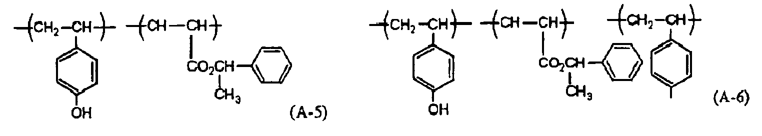

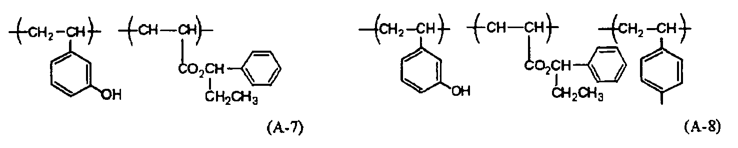

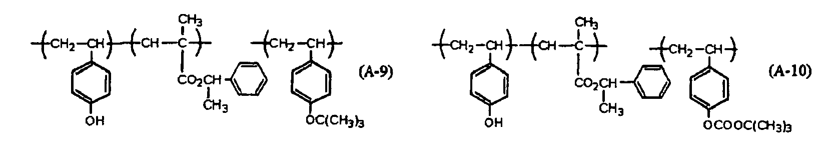

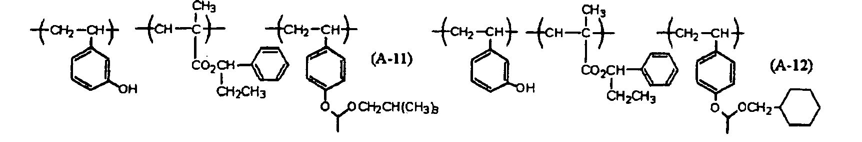

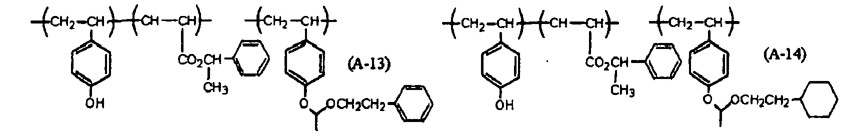

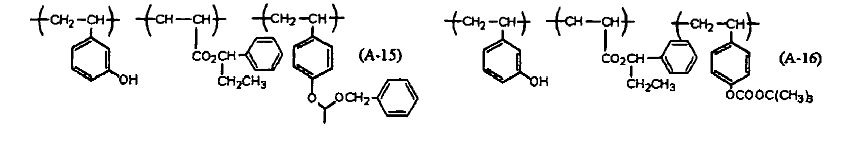

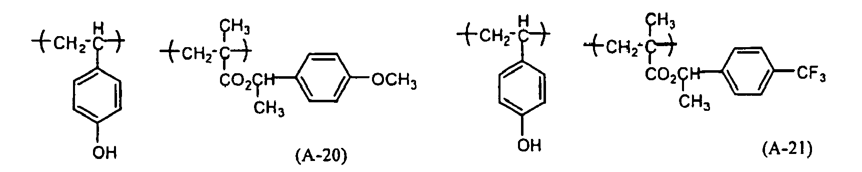

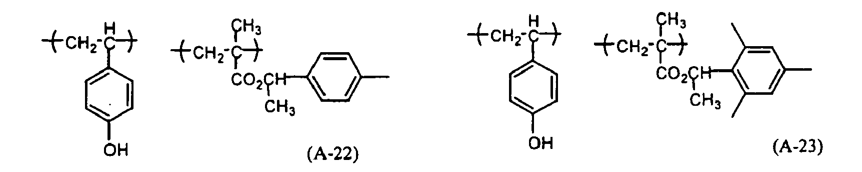

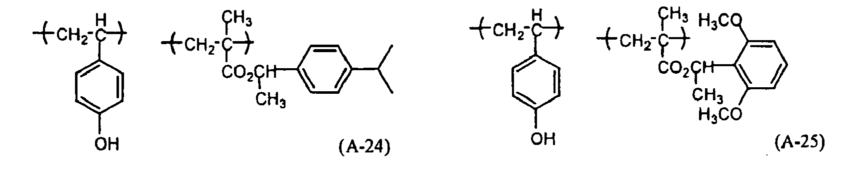

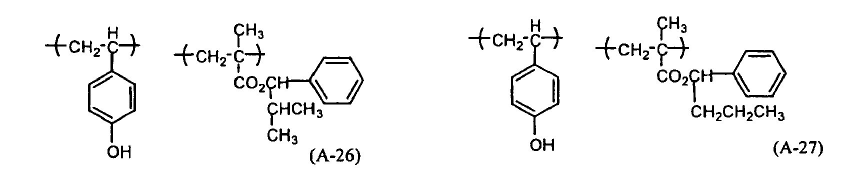

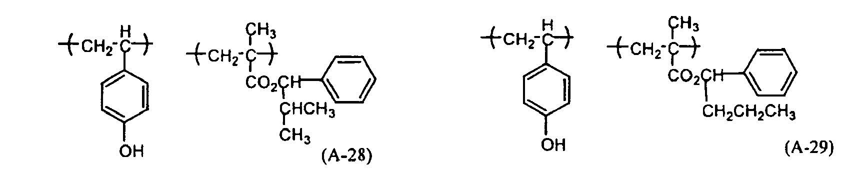

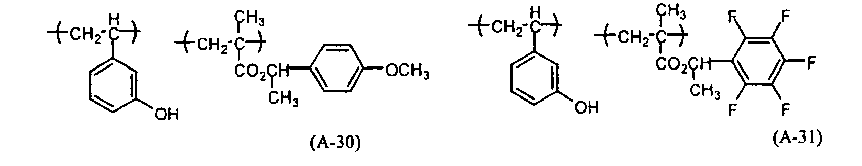

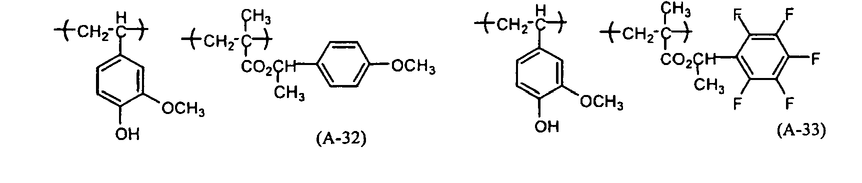

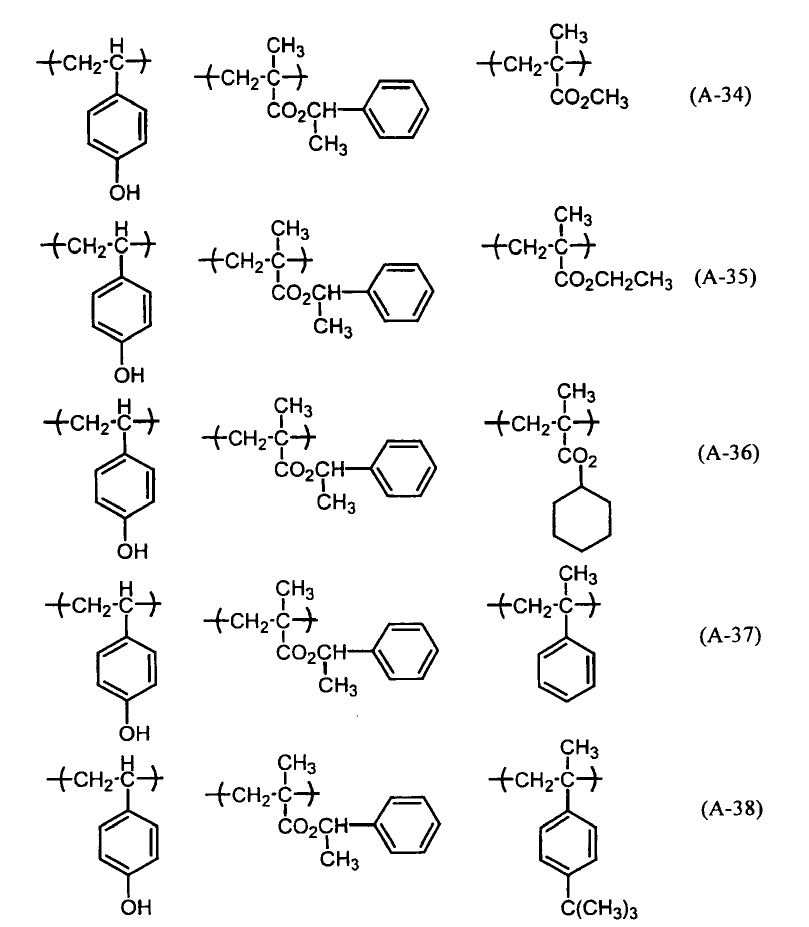

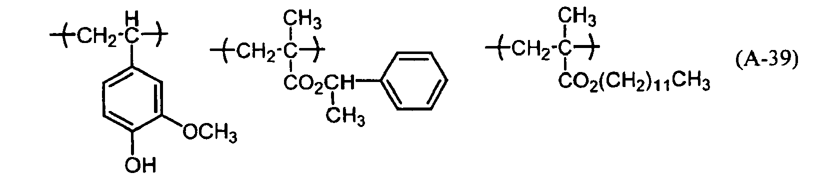

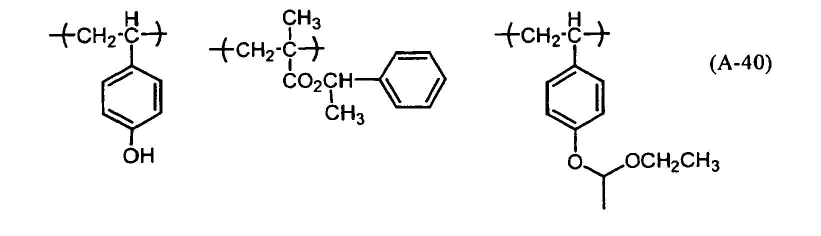

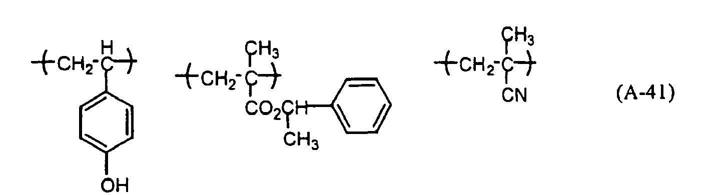

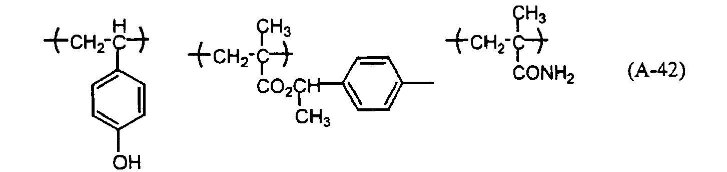

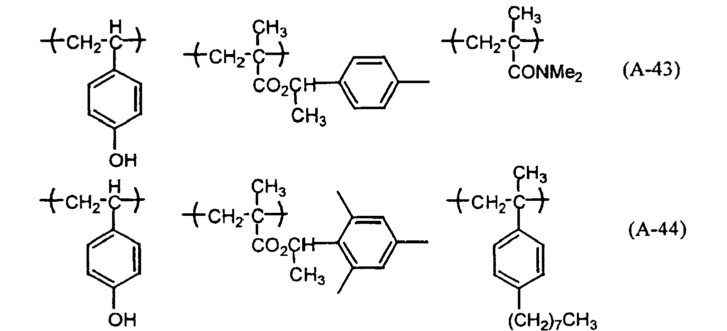

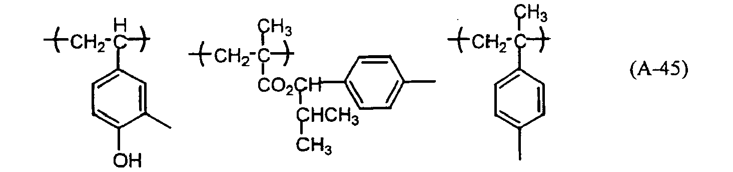

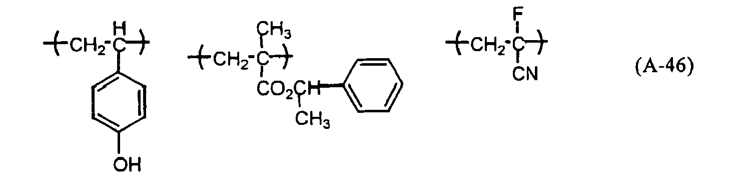

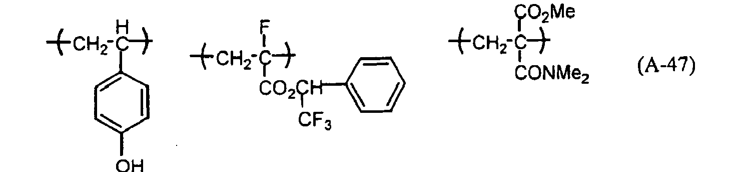

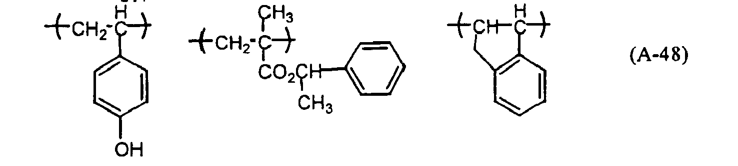

In the case of irradiating KrF excimer laser light, electron beam, X ray or high-energy beam at a wavelength of 50 nm or less (e.g., EUV) on the positive resist composition of the present invention, a hydroxystyrene copolymer protected by hydroxystyrene/acid-decomposable group, or a hydroxystyrene/tertiary alkyl (meth)acrylate copolymer is preferably used together with the resin (A).

Specific examples thereof are set forth below, but the present invention is not limited thereto. In specific examples, tBu indicates a tert-butyl group.

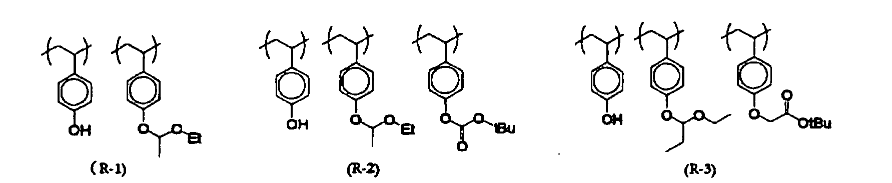

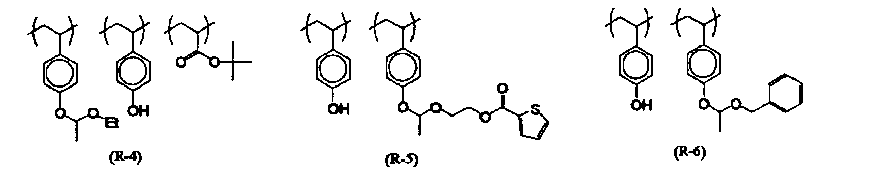

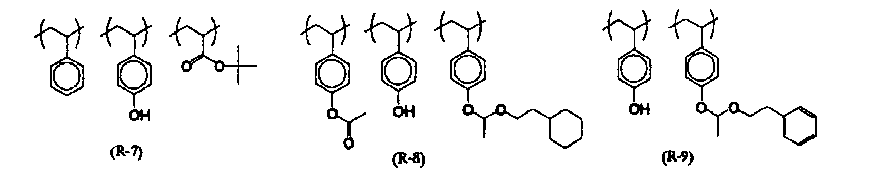

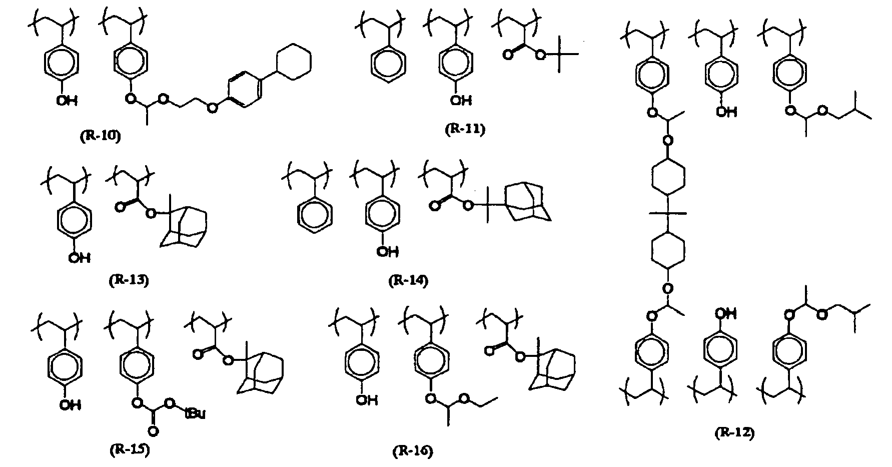

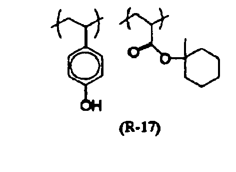

### [2] (B) Compound capable of generating acid upon irradiation with an actinic ray or radiation

The compound capable of generating an acid upon irradiation with an actinic ray or radiation (hereinafter, sometimes referred to as an "acid generator"), contained in the positive resist composition of the present invention, is preferably a compound capable of generating a sulfonic acid upon irradiation with an actinic ray or radiation.

The compound capable of generating a sulfonic acid upon irradiation with an actinic ray or radiation (hereinafter, sometimes referred to as a "sulfonic acid generator") is a compound which generates a sulfonic acid upon irradiation with an actinic ray or radiation such as KrF excimer laser, electron beam and EUV, and examples thereof include diazonium salt, phosphonium salt, sulfonium salt, iodonium salt, imidosulfonate, oxime sulfonate, diazodisulfone, disulfone and o-nitrobenzylsulfonate.

Also, a compound where such a group or compound capable of generating an acid upon irradiation with an actinic ray or radiation is introduced into the main or side chain of a polymer may be used, and examples thereof include the compounds described in U.S. Patent 3,849,137, German Patent 3,914,407, JP-A-63-26653, JP-A-55-164824, JP-A-62-69263, JP-A-63-146038, JP-A-63-163452, JP-A-62-153853 and JP-A-63-146029.

Furthermore, the compounds capable of generating a sulfonic acid by the effect of light described, for example, in U.S. Patent 3,779,778 and European Patent 126,712 may also be used.

In the present invention, from the standpoint of enhancing the image performance such as resolving power and pattern profile, a sulfonium salt, an iodonium salt, an imidosulfonate, an oxime sulfonate, a diazodisulfone and a disulfone are preferred as the sulfonic acid generator.

Preferred sulfonic acid generators include compounds represented by the following formulae (ZI), (ZII) and (ZIII):

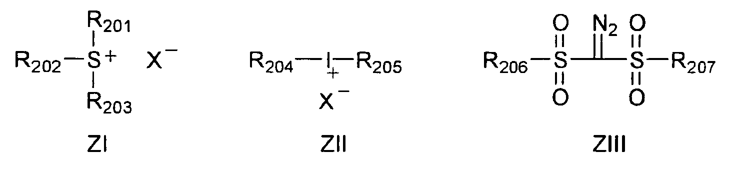

In formula (ZI), R₂₀₁, R₂₀₂ and R₂₀₃ each independently represents an organic group. Two members out of R₂₀₁ to R₂₀₃ may combine to form a ring structure.

X⁻ represents an organic sulfonate anion.

The number of carbons in the organic group as R₂₀₁, R₂₀₂ and R₂₀₃ is generally from 1 to 30, preferably from 1 to 20.

Examples of the group formed after two members out of R₂₀₁ to R₂₀₃ are combined include an alkylene group (e.g., butylene, pentylene), and the ring may contain an oxygen atom, a sulfur atom, an ester bond, an amide bond or a carbonyl group.

Specific examples of the organic group as R₂₀₁, R₂₀₂ and R₂₀₃ include corresponding groups in the compounds (ZI-1), (ZI-2) and (ZI-3) which are described later.

The compound may be a compound having a plurality of structures represented by formula (Z1), for example, a compound having a structure where at least one of R₂₀₁ to R₂₀₃ in the compound represented by formula (Z1) is bonded to at least one of R₂₀₁ to R₂₀₃ in another compound represented by formula (Z1).

The component (Z1) is more preferably a compound (ZI-1), (ZI-2) or (ZI-3) described below.

The compound (ZI-1) is an arylsulfonium compound where at least one of R₂₀₁ to R₂₀₃ in formula (Z1) is an aryl group, that is, a compound having an arylsulfonium as the cation.

In the arylsulfonium compound, R₂₀₁ to R₂₀₃ all may be an aryl group or a part of R₂₀₁ to R₂₀₃ may be an aryl group with the remaining being an alkyl group or a cycloalkyl group.

Examples of the arylsulfonium compound include a triarylsulfonium compound, a diarylalkylsulfonium compound, an aryldialkylsulfonium compound, a diarylcycloalkylsulfonium compound and an aryldicycloalkylsulfonium compound.

The aryl group in the arylsulfonium compound includes an aryl group composed of hydrocarbon and a heteroaryl group having a heteroatom such as nitrogen atom, sulfur tom and oxygen atom. The aryl group composed of hydrocarbon is preferably a phenyl group or a naphthyl group, more preferably a phenyl group. Examples of the heteroaryl group include a pyrrole group, an indole group, a carbazole group, a furan group and a thiophene group, with an indole group being preferred. In the case where the arylsulfonium compound has two or more aryl groups, these two or more aryl groups may be the same of different.

The alkyl group which is present, if desired, in the arylsulfonium compound is preferably a linear or branched alkyl group having a carbon number of 1 to 15, and examples thereof include a methyl group, an ethyl group, a propyl group, an n-butyl group, a sec-butyl group and a tert-butyl group.

The cycloalkyl group which is present, if desired, in the arylsulfonium compound is preferably a cycloalkyl group having a carbon number of 3 to 15, and examples thereof include a cyclopropyl group, a cyclobutyl group and a cyclohexyl group.

The aryl group, alkyl group and cycloalkyl group of R₂₀₁ to R₂₀₃ each may have, as the substituent, an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 14), an alkoxy group (for example, an alkoxy group having a carbon number of 1 to 15), a halogen atom, a hydroxyl group or a phenylthio group. The substituent is preferably a linear or branched alkyl group having a carbon number of 1 to 12, a cycloalkyl group having a carbon number of 3 to 12, or an alkoxy group having a carbon number of 1 to 12, more preferably an alkyl group having a carbon number of 1 to 4, or an alkoxy group having a carbon number of 1 to 4. The substituent may be substituted to any one of three members R₂₀₁ to R₂₀₃ or may be substituted to all of these three members. In the case where R₂₀₁ to R₂₀₃ each is an aryl group, the substituent is preferably substituted at the p-position of the aryl group.

Examples of the organic sulfonate anion of X- include aliphatic sulfonate anion, aromatic sulfonate anion and camphorsulfonate anion.

Examples of the aliphatic group in the aliphatic sulfonate anion include an alkyl group having a carbon number of 1 to 30, such as methyl group, ethyl group, propyl group, isopropyl group, n-butyl group, isobutyl group, sec-butyl group, pentyl group, neopentyl group, hexyl group, heptyl group, octyl group, nonyl group, decyl group, undecyl group, dodecyl group, tridecyl group, tetradecyl group, pentadecyl group, hexadecyl group, heptadecyl group, octadecyl group, nonadecyl group and eicosyl group, and a cycloalkyl group having a carbon number of 3 to 30, such as cyclopropyl group, cyclopentyl group, cyclohexyl group, adamantyl group, norbornyl group and boronyl group.

The aromatic group in the aromatic sulfonate anion is preferably an aryl group having a carbon number of 6 to 14, such as phenyl group, tolyl group and naphthyl group.

The alkyl group, cycloalkyl group and aryl group in the aliphatic sulfonate anion and aromatic sulfonate anion each may have a substituent.

Examples of the substituent include a nitro group, a halogen atom (e.g., fluorine, chlorine, bromine, iodine), a carboxyl group, a hydroxyl group, an amino group, a cyano group, an alkoxy group (preferably having a carbon number of 1 to 5), a cycloalkyl group (preferably having a carbon number of 3 to 15), an aryl group (preferably having a carbon number of 6 to 14), an alkoxycarbonyl group (preferably having a carbon number of 2 to 7), an acyl group (preferably having a carbon number of 2 to 12), an alkoxycarbonyloxy group (preferably having a carbon number of 2 to 7) and an alkylthio group (preferably having a carbon number of 1 to 15). As for the aryl group and ring structure in each group, examples of the substituent further include an alkyl group (preferably having a carbon number of 1 to 15).

The organic sulfonate anion of X- is preferably an aliphatic sulfonate anion with the α-position of the sulfonic acid being substituted by a fluorine atom, or an aromatic sulfonate anion substituted by a fluorine atom or a fluorine atom-containing group. The organic sulfonate anion is more preferably a perfluoro aliphatic sulfonate anion having a carbon number of 4 to 8, or an aromatic sulfonate anion having a fluorine atom, still more preferably nonafluorobutanesulfonate anion, perfluorooctanesulfonate anion, pentafluorobenzenesulfonate anion or 3,5-bis(trifluoromethyl)benzenesulfonate anion.

The compound (ZI-2) is described below.

The compound (ZI-2) is a compound where R₂₀₁ to R₂₀₃ in formula (ZI) each independently represents an aromatic ring-free organic group.

The aromatic ring-free organic group as R₂₀₁ to R₂₀₃ generally has a carbon number of 1 to 30, preferably from 1 to 20.

R₂₀₁ to R₂₀₃ each independently represents preferably an alkyl group, a cycloalkyl group, an allyl group or a vinyl group, more preferably a linear, branched or cyclic 2-oxoalkyl group or an alkoxycarbonylmethyl group, still more preferably a linear or branched 2-oxoalkyl group.

The alkyl group of R₂₀₁ to R₂₀₃ may be linear or branched and is preferably a linear or branched alkyl group having a carbon number of 1 to 10, and examples thereof include a methyl group, an ethyl group, a propyl group, a butyl group and a pentyl group. The alkyl group is more preferably a linear or branched 2-oxoalkyl group or an alkoxycarbonylmethyl group.

The cycloalkyl group of R₂₀₁ to R₂₀₃ is preferably a cycloalkyl group having a carbon number of 3 to 10, and examples thereof include a cyclopentyl group, a cyclohexyl group and a norbornyl group. The cycloalkyl group is more preferably a cyclic 2-oxoalkyl group.

The 2-oxoalkyl group may be linear, branched or cyclic and is preferably a group having >C=O at the 2-position of the above-described alkyl or cycloalkyl group.

The alkyl group in the alkoxycarbonylmethyl group is preferably an alkyl group having a carbon number of 1 to 5 (e.g., methyl, ethyl, propyl, butyl, pentyl).

R₂₀₁, to R₂₀₃ each may be further substituted by a halogen atom, an alkoxy group (for example, an alkoxy group having a carbon number of 1 to 5), a hydroxyl group, a cyano group or a nitro group.

The compound (ZI-3) is a compound represented by the following formula (ZI-3), and this is a compound having a phenacylsulfonium salt structure.

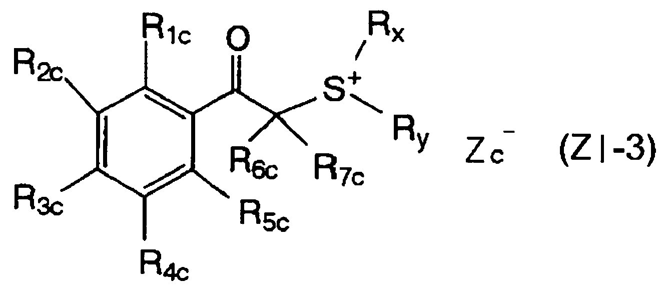

In formula (ZI-3), R_{1c} to R_{5c} each independently represents a hydrogen atom, an alkyl group, a cycloalkyl group, an alkoxy group or a halogen atom.

R_{6c} and R_{7c} each represents a hydrogen atom, an alkyl group or a cycloalkyl group.

Rₓ and R_{y} each independently represents an alkyl group, a cycloalkyl group, an allyl group or a vinyl group.

Any two or more members out of R_{1c} to R_{7c} or the pair of Rₓ and R_{y} may combine with each other to form a ring structure, and the ring structure may contain an oxygen atom, a sulfur atom, an ester bond or an amide bond. Examples of the group formed after any two or more members out of R_{1c} to R_{7c} or the pair of Rₓ and R_{y} are combined include a butylene group and a pentylene group.

Zc⁻ represents an organic sulfonate anion, and examples thereof are the same as those of the n organic sulfonate anion of X⁻ in formula (ZI).

The alkyl group as R_{1c} to R_{7c} is preferably a linear or branched alkyl group having a carbon number of 1 to 20, and examples thereof include a methyl group, an ethyl group, a linear or branched propyl group, a linear or branched butyl group and a linear or branched pentyl group.

The cycloalkyl group as R_{1c} to R_{7c} is preferably a cycloalkyl group having a carbon number of 3 to 8, and examples thereof include a cyclopentyl group and a cyclohexyl group.

The alkoxy group as R_{1c} to R_{5c} may be linear, branched or cyclic and is, for example, an alkoxy group having a carbon number of 1 to 10, preferably a linear or branched alkoxy group having a carbon number of 1 to 5 (e.g., methoxy, ethoxy, linear or branched propoxy, linear or branched butoxy, linear or branched pentoxy) or a cyclic alkoxy group having a carbon number of 3 to 8 (e.g., cyclopentyloxy, cyclohexyloxy).

A compound where any one of R_{1c} to R_{5c} is a linear or branched alkyl group, a cycloalkyl group or a linear, branched or cyclic alkoxy group is preferred, and a compound where the sum of carbon atoms of R_{1c} to R_{5c} is from 2 to 15 is more preferred. In this case, the solubility in a solvent is more enhanced and the generation of particles during storage is suppressed.

Examples of the alkyl group and cycloalkyl group as Rₓ and R_{y} are the same as those of the alkyl group and cycloalkyl group of R_{1c} to R_{7c}. Among these, a 2-oxoalkyl group and an alkoxycarbonylmethyl group are preferred.

Examples of the 2-oxoalkyl group include a group having >C=O at the 2-position of the alkyl or cycloalkyl group of R_{1c} to R_{7c}.

Examples of the alkoxy group in the alkoxycarbonylmethyl group are the same as those of the alkoxy group of R_{1c} to R_{5c}.

Rₓ and R_{y} each is preferably an alkyl group having a carbon number of 4 or more, more preferably 6 or more, still more preferably 8 or more.

In formulae (ZII) and (ZIII), R₂₀₄ to R₂₀₇ each independently represents an aryl group, an alkyl group or a cycloalkyl group.

The aryl group of R₂₀₄ to R₂₀₇ includes an aryl group composed of a hydrocarbon, and an aryl group having a heteroatom such as nitrogen atom, sulfur atom and oxygen atom. The aryl group composed of a hydrocarbon is preferably a phenyl group or a naphthyl group, more preferably a phenyl group. Examples of the heteroaryl group include a pyrrole group, an indole group, a carbazole group, a furan group and a thiophene group, with an indole group being preferred.

The alkyl group of R₂₀₄ to R₂₀₇ is preferably a linear or branched alkyl group having a carbon number of 1 to 10, and examples thereof include a methyl group, an ethyl group, a propyl group, a butyl group and a pentyl group.

The cycloalkyl group of R₂₀₄ to R₂₀₇ is preferably a cycloalkyl group having a carbon number of 3 to 10, and examples thereof include a cyclopentyl group, a cyclohexyl group and a norbornyl group.

Examples of the substituent which R₂₀₄ to R₂₀₇ each may have include an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 15), an alkoxy group (for example, an alkoxy group having a carbon number of 1 to 15), a halogen atom, a hydroxyl group and a phenylthio group.

X' represents an organic sulfonate anion, and examples thereof are the same as those of the organic sulfonate anion of X⁻ in formula (ZI).

The preferred sulfonic acid generator further includes compounds represented by the following formulae (ZIV), (ZV) and (ZVI).

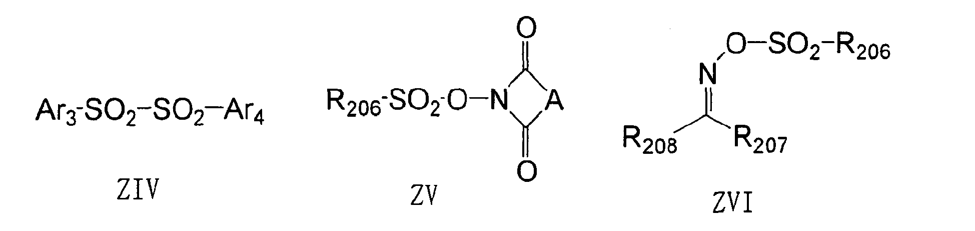

In formulae (ZIV) to (ZVI), Ar₃ and Ar₄ each independently represents an aryl group.

R₂₀₆, R₂₀₇ and R₂₀₈ each represents an alkyl group, a cycloalkyl group or an aryl group.

A represents an alkylene group, an alkenylene group or an arylene group.

The preferred sulfonic acid generator further includes a compound represented by the following formula (ZVII).

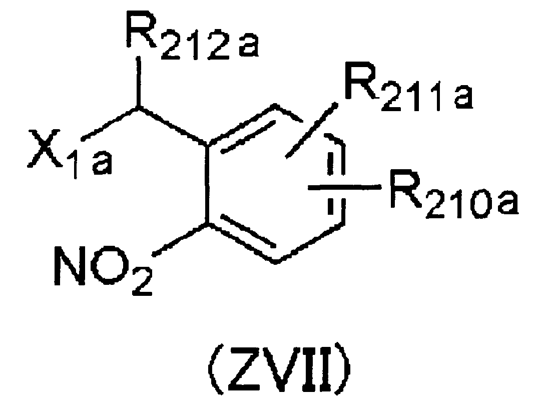

In formula (ZVII), R₂₁₀ₐ and R₂₁₁, each independently represents a hydrogen atom, an alkyl group, a cycloalkyl group, a cyano group, a nitro group or an alkoxycarbonyl group and is preferably a halogen-substituted alkyl or cycloalkyl group, a nitro group or a cyano group.

R₂₁₂ₐ represents a hydrogen atom, an alkyl group, a cycloalkyl group, a cyano group or an alkoxycarbonyl group.

X₁ₐ represents a monovalent group resulting from removal of the hydrogen atom of-SO₃H of an organic sulfonic acid.

The preferred sulfonic acid generator further includes a compound represented by the following formula (ZVIII).

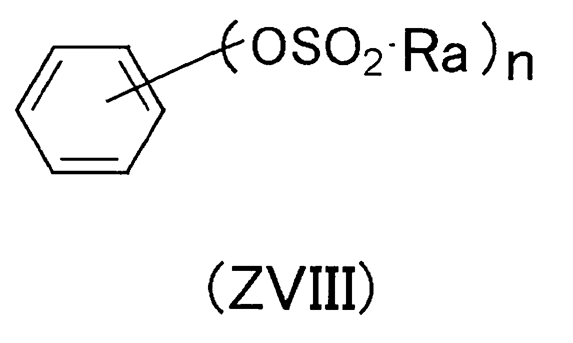

In formula (ZVIII), Ra represents an alkyl group, a cycloalkyl group or an aryl group. In the case where a plurality of Ra's are present, the plurality of Ra's may be the same or different.
n represents an integer of 1 to 6.

Specific examples of the sulfonic acid generator are set forth below, but the present invention is not limited thereto.

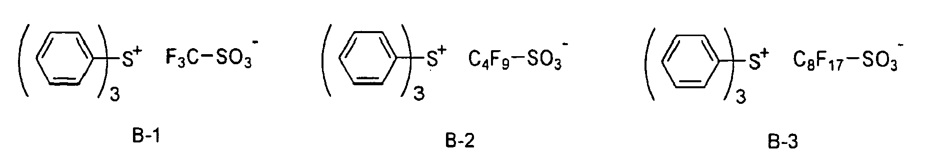

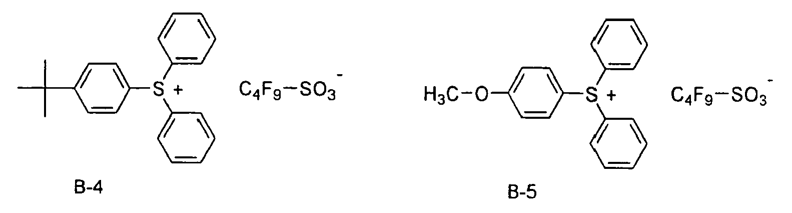

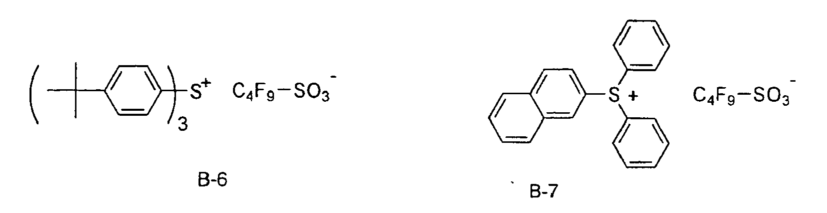

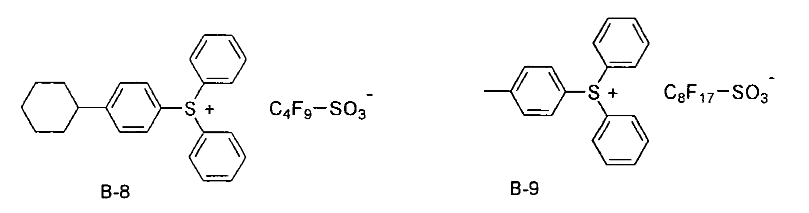

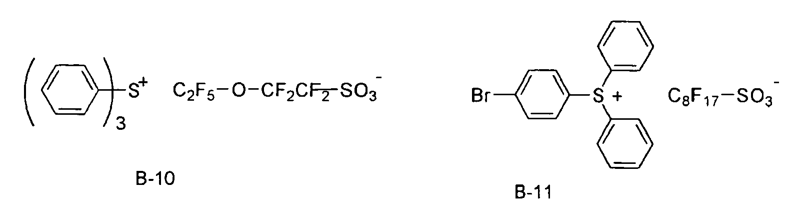

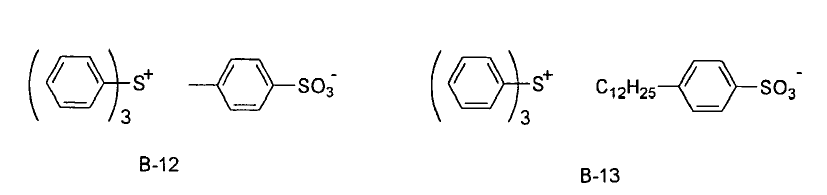

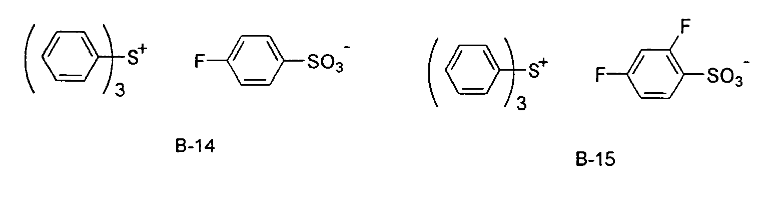

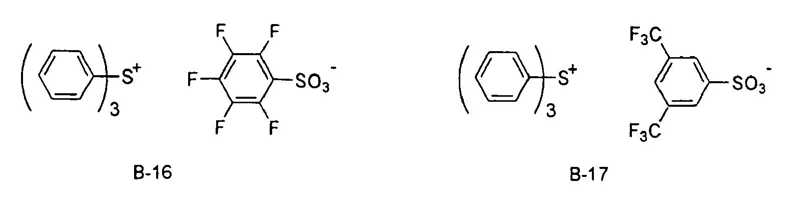

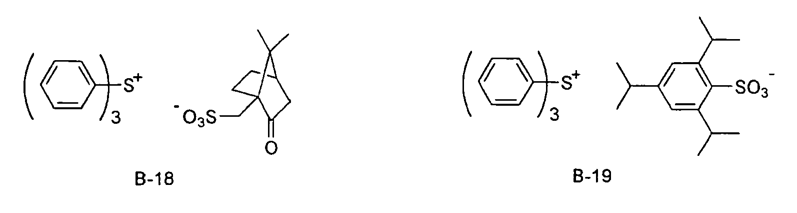

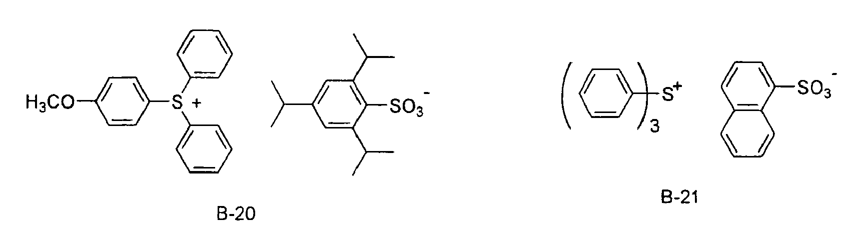

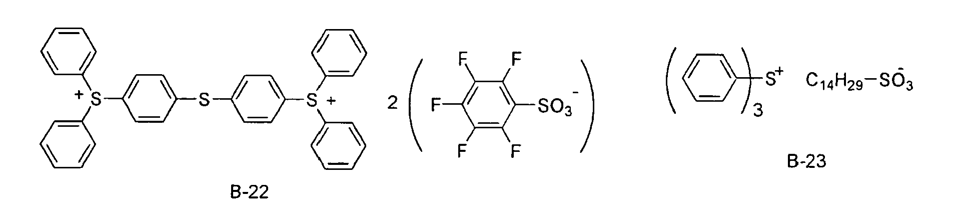

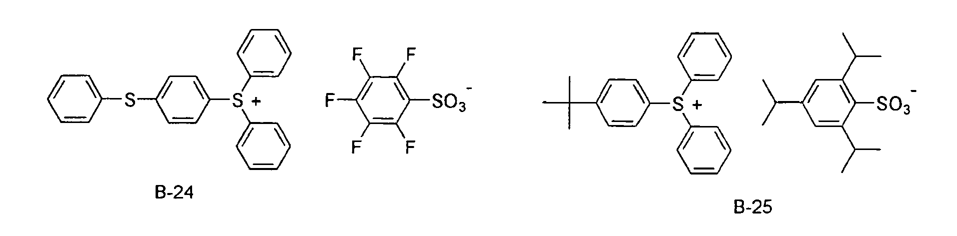

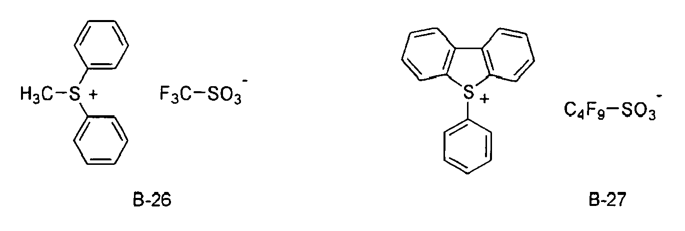

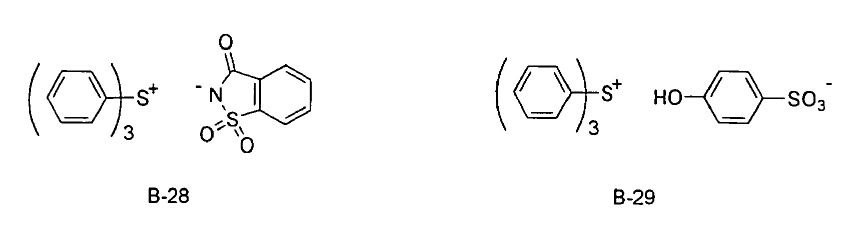

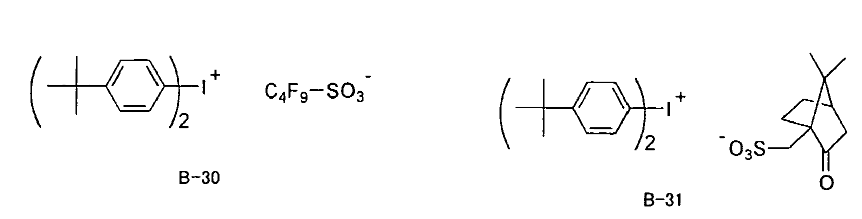

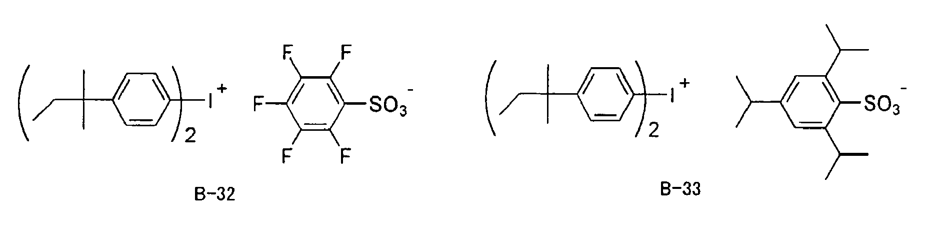

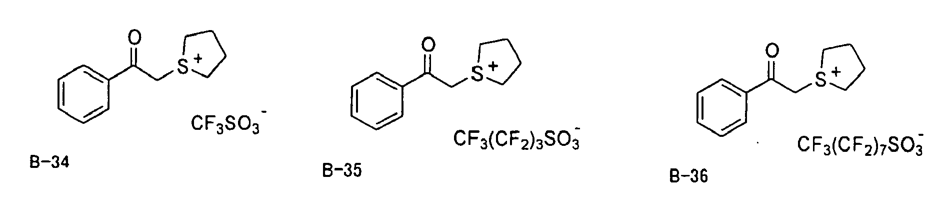

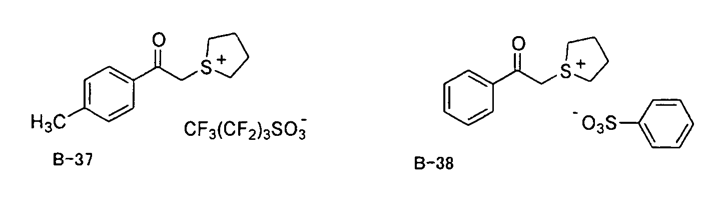

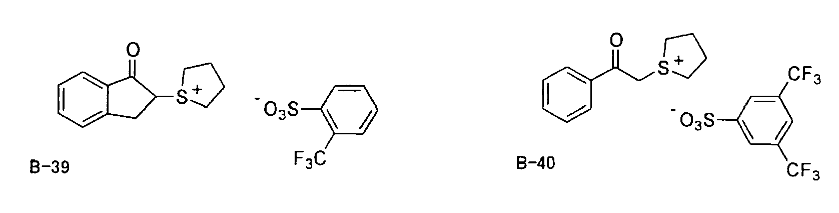

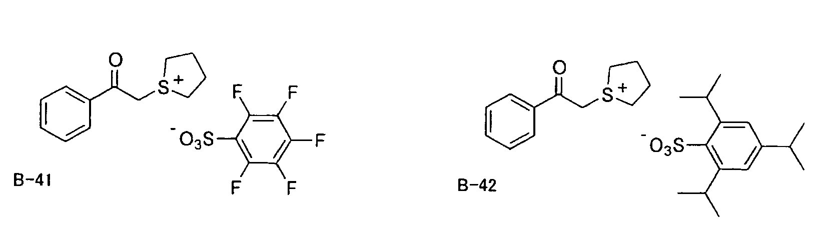

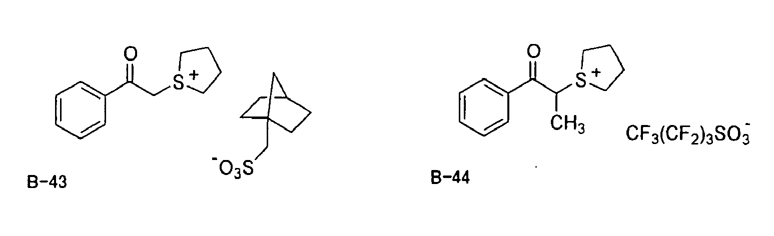

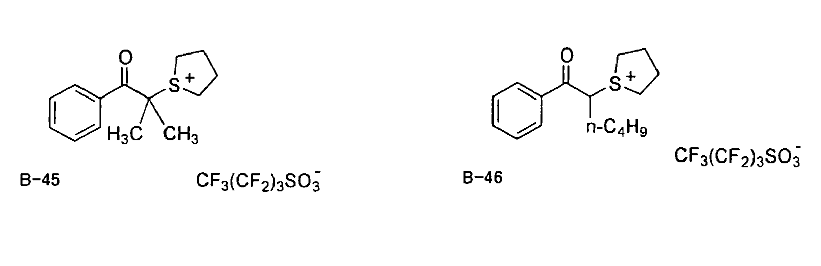

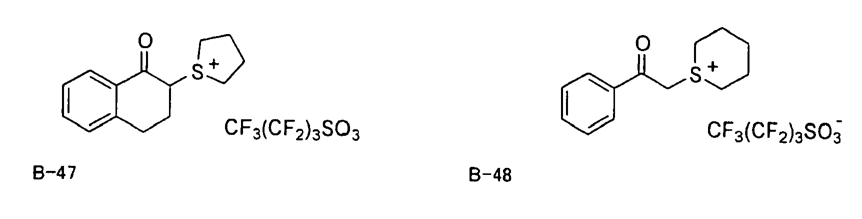

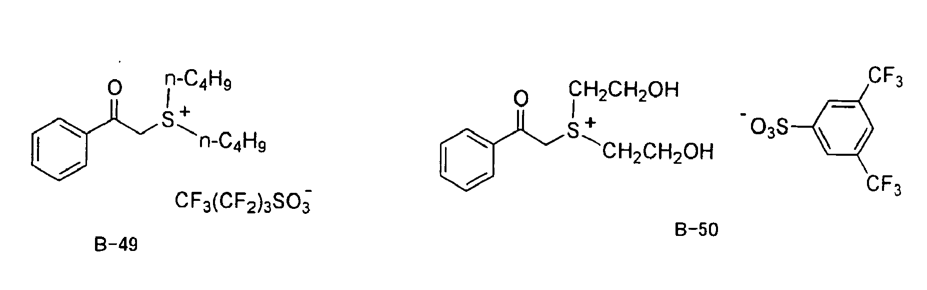

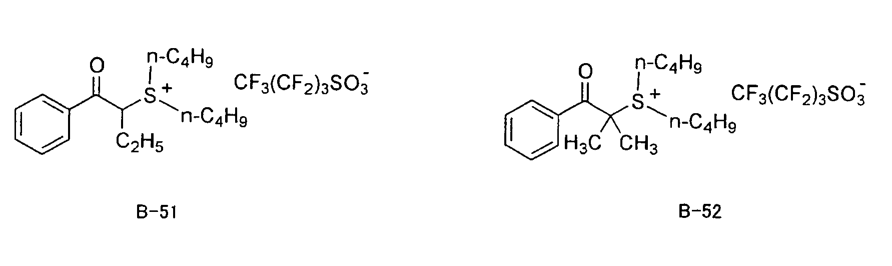

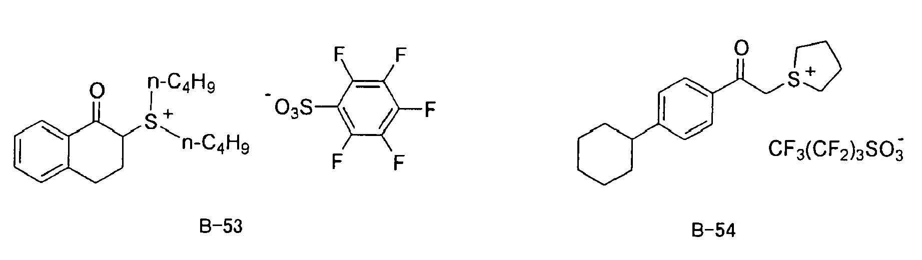

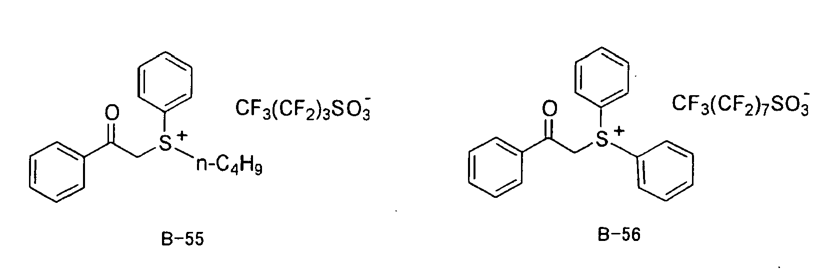

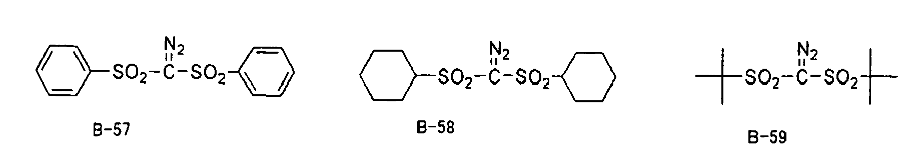

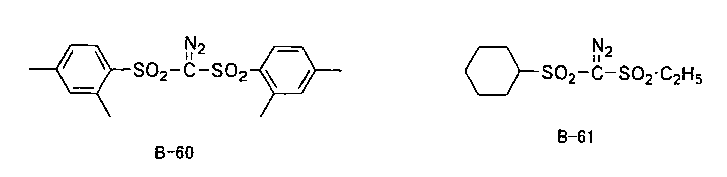

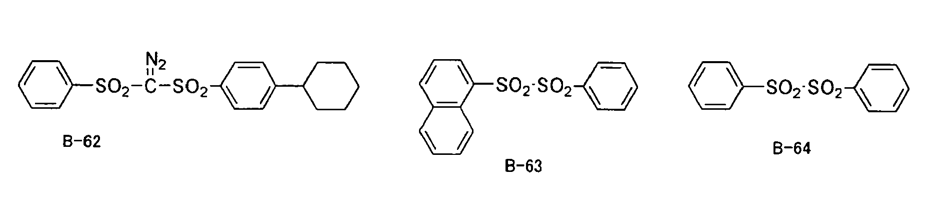

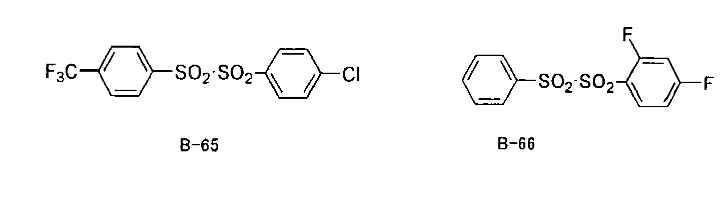

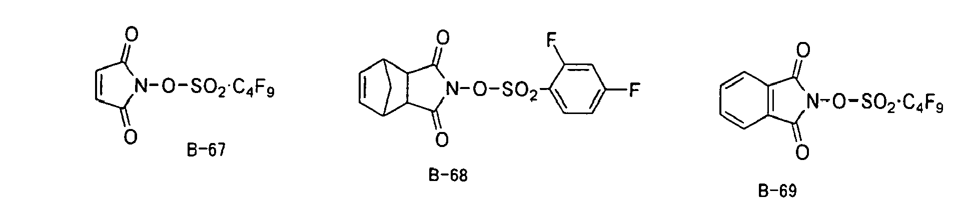

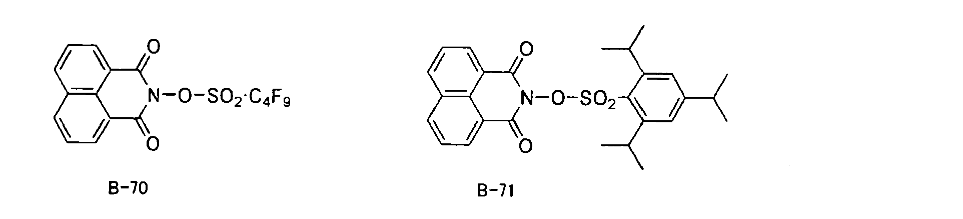

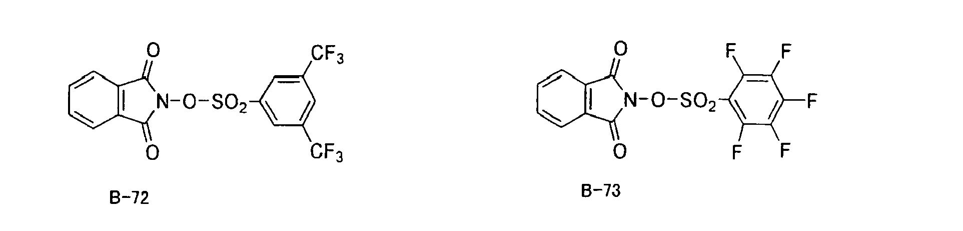

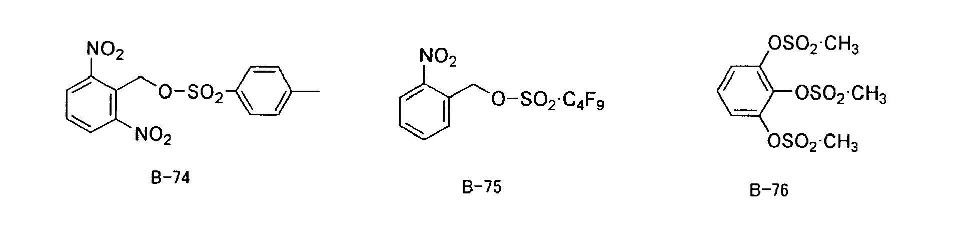

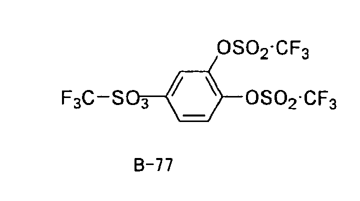

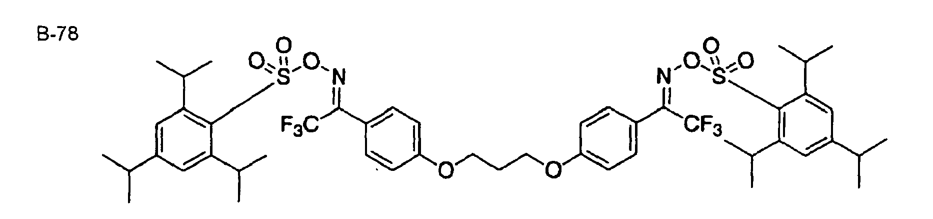

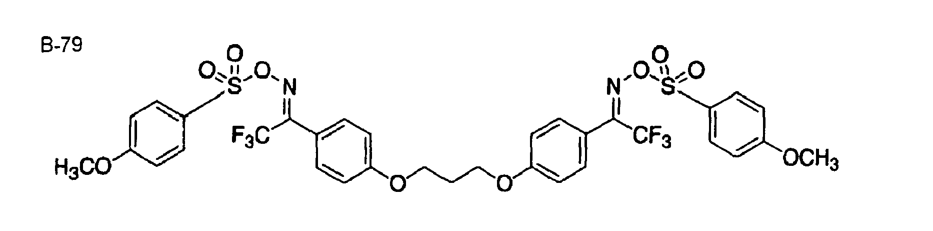

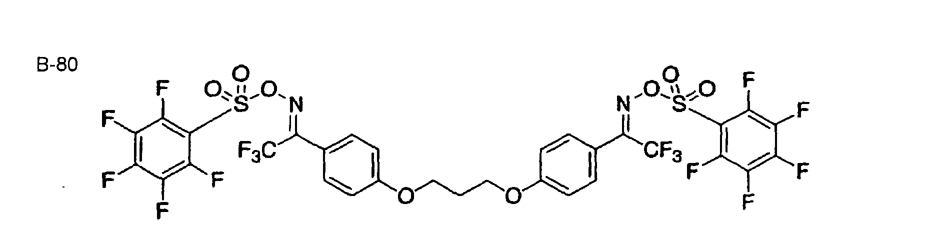

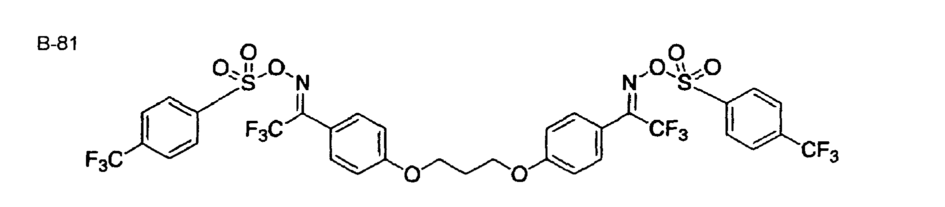

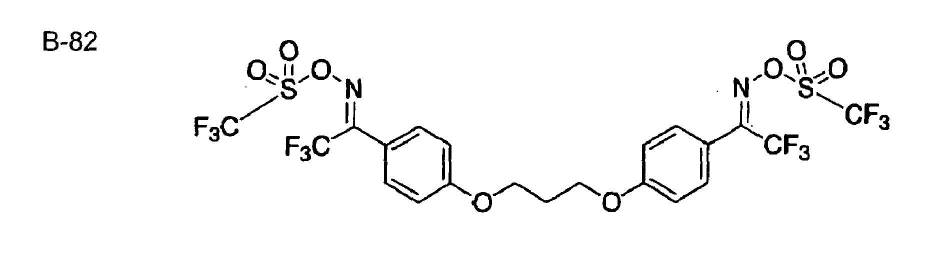

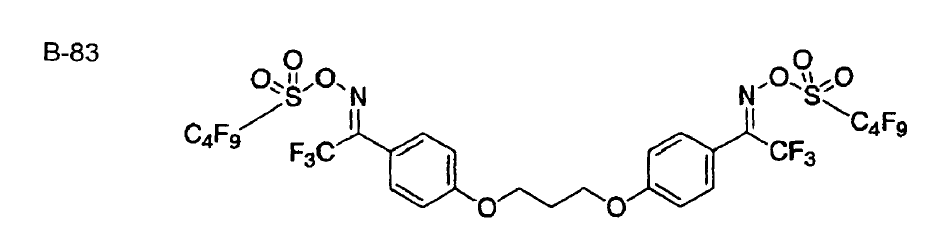

The content of the sulfonic acid generator is from 5 to 20 mass%, preferably from 6 to 18 mass%, more preferably from 7 to 16 mass%, based on the entire solid content of the resist composition. The content is 5 mass% or more in view of sensitivity or line edge roughness and 20 mass% or less in view of resolving power, pattern profile and film quality. One kind of the sulfonic acid generator may be used, or two or more kinds thereof may be mixed and used. For example, a compound capable of generating an arylsulfonic acid upon irradiation with an actinic ray or radiation and a compound capable of generating an alkylsulfonic acid upon irradiation with an actinic ray or radiation may be used in combination as the sulfonic acid generator.

The sulfonic acid generator can be synthesized by a known method such as the synthesis method described in JP-A-2002-27806.

In the positive resist composition of the present invention, a compound capable of generating a carboxylic acid upon irradiation with an actinic ray or radiation (hereinafter, sometimes referred to as a "carboxylic acid generator") may be used in combination with the sulfonic acid generator.

The carboxylic acid generator is preferably a compound represented by the following formula (C):

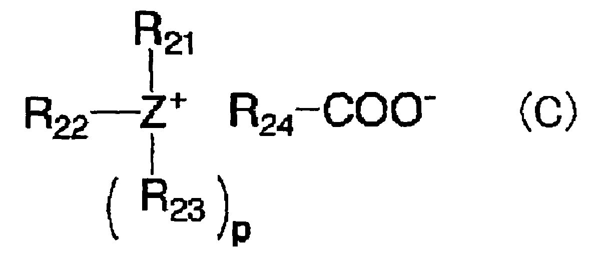

In formula (C), R₂₁ to R₂₃ each independently represents an alkyl group, a cycloalkyl group, an alkenyl group or an aryl group.

R₂₄ represents a hydrogen atom, an alkyl group, a cycloalkyl group, an alkenyl group or an aryl group.

Z represents a sulfur atom or an iodine atom. p is 1 when Z is a sulfur atom, and p is 0 when Z is an iodine atom.

In formula (C), R₂₁ to R₂₃ each independently represents an alkyl group, a cycloalkyl group, an alkenyl group or an aryl group, and these groups each may have a substituent.

Examples of the substituent which the alkyl group, cycloalkyl group and alkenyl group each may have include a halogen atom (e.g., chlorine, bromine, fluorine), an aryl group (e.g., phenyl, naphthyl), a hydroxy group and an alkoxy group (e.g., methoxy, ethoxy, butoxy).

Examples of the substituent which the aryl group may have include a halogen atom (e.g., chlorine, bromine, fluorine), a nitro group, a cyano group, an alkyl group (e.g., methyl, ethyl, tert-butyl, tert-amyl, octyl), a hydroxy group and an alkoxy group (e.g., methoxy, ethoxy, butoxy).

R₂₁ to R₂₃ each is independently preferably an alkyl group having a carbon number of 1 to 12, a cycloalkyl group having a carbon number of 3 to 12, an alkenyl group having a carbon number of 2 to 12 or an aryl group having a carbon number of 6 to 24, more preferably an alkyl group having a carbon number of 1 to 6, a cycloalkyl group having a carbon number of 3 to 6 or an aryl group having a carbon number of 6 to 18, still more preferably an aryl group having a carbon number of 6 to 15, and these groups each may have a substituent.

R₂₄ represents a hydrogen atom, an alkyl group, a cycloalkyl group, an alkenyl group or an aryl group.

Examples of the substituent which the alkyl group, cycloalkyl group and alkenyl group each may have are the same as those of the substituent described above when R₂₁ is an alkyl group. Examples of the substituent for the aryl group are the same as those of the substituent described above when R₂₁ is an aryl group.

R₂₄ is preferably a hydrogen atom, an alkyl group having a carbon number of 1 to 30, a cycloalkyl group having a carbon number of 3 to 30, an alkenyl group having a carbon number of 2 to 30 or an aryl group having a carbon number of 6 to 24, more preferably an alkyl group having a carbon number of 1 to 18, a cycloalkyl group having a carbon number of 3 to 18 or an aryl group having a carbon number of 6 to 18, still more preferably an alkyl group having a carbon number of 1 to 12, a cycloalkyl group having a carbon number of 3 to 12 or an aryl group having a carbon number of 6 to 15. These groups each may have a substituent.

Z represents a sulfur atom or an iodine atom. p is 1 when Z is a sulfur atom, and 0 when Z is an iodine atom.

Incidentally, two or more cation moieties of formula (C) may combine through a single bond or a linking group (e.g., -S-, -O-) to form a cation structure having a plurality of cation moieties of formula (C).

Specific preferred examples of the compound capable of generating a carboxylic acid upon irradiation with an actinic ray or radiation are set forth below, but the present invention is of course not limited thereto.

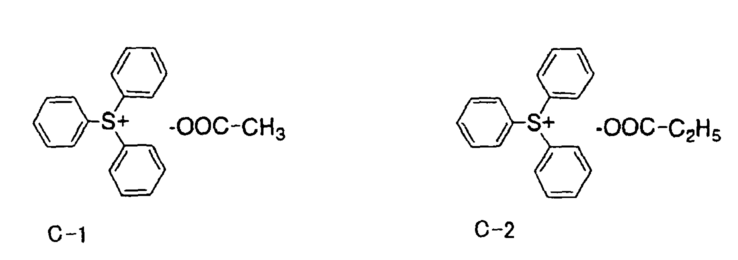

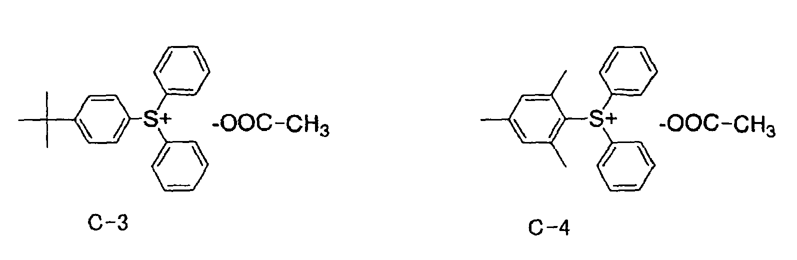

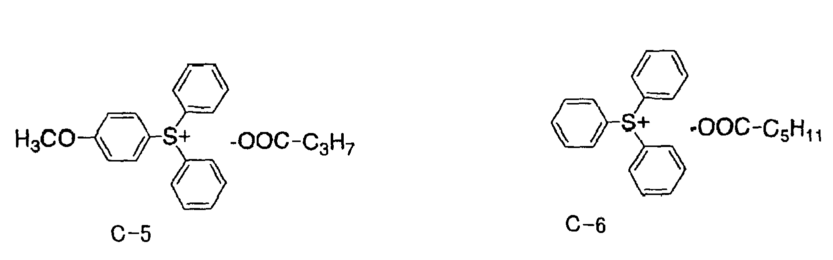

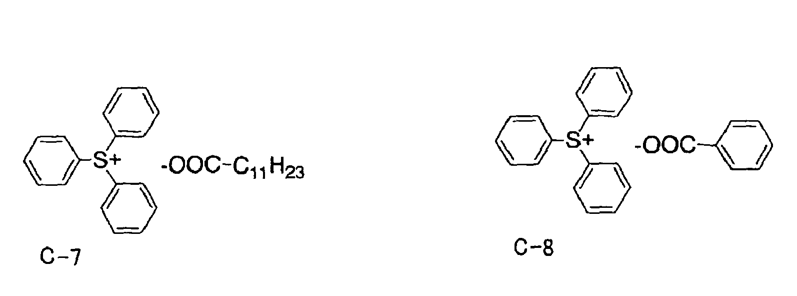

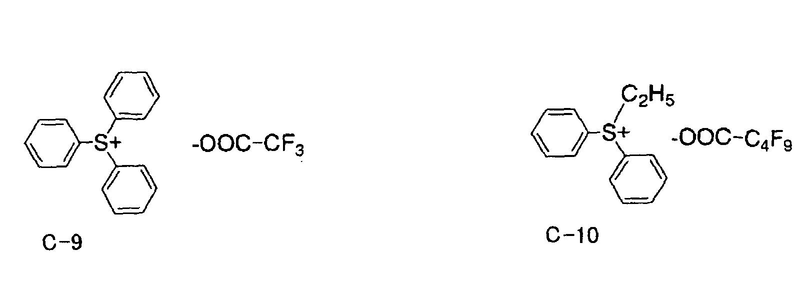

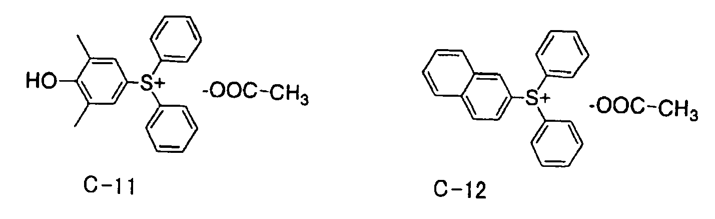

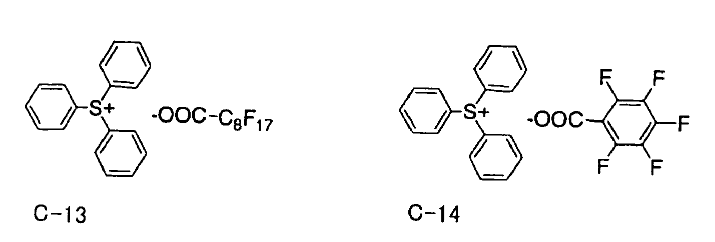

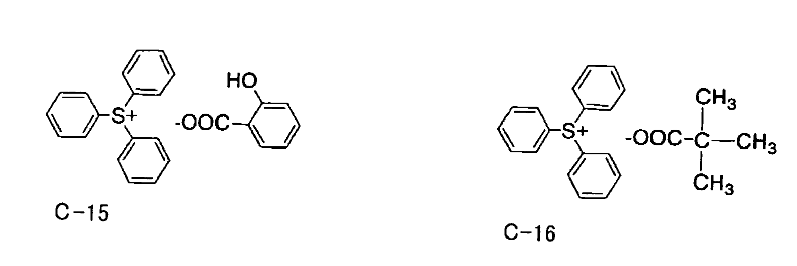

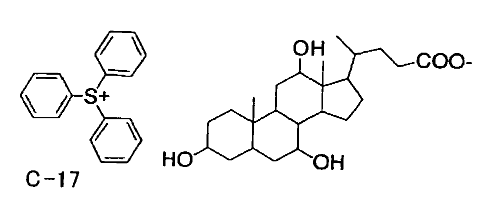

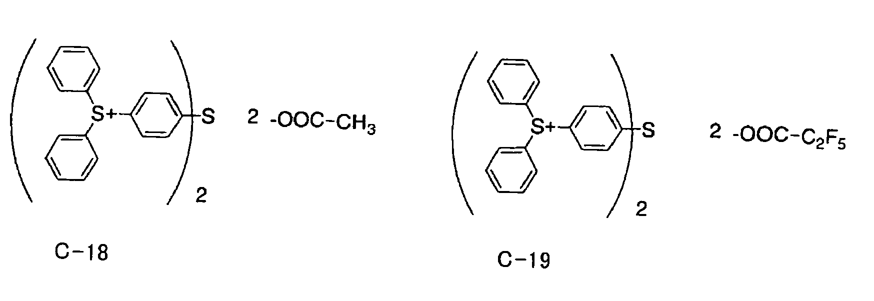

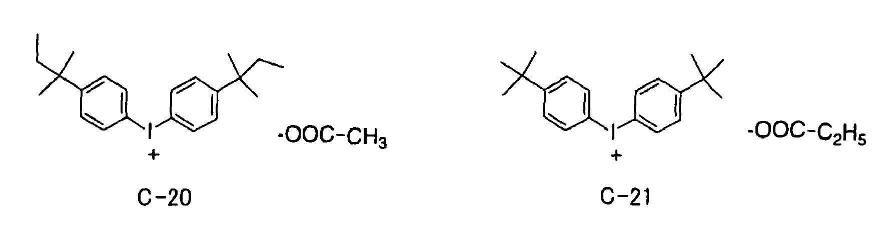

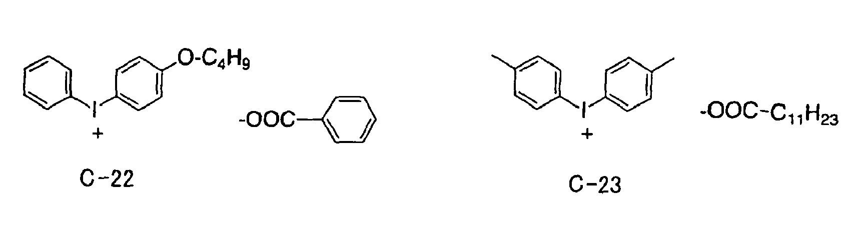

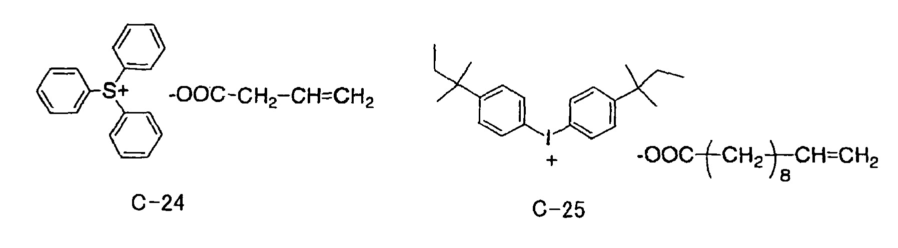

The content of the carboxylic acid generator in the positive resist composition of the present invention is preferably from 0.01 to 10 mass%, more preferably from 0.03 to 5 mass%, still more preferably from 0.05 to 3 mass%, based on the entire solid content of the composition. One of these compounds capable of generating a carboxylic acid upon irradiation with an actinic ray or radiation may be used, or two or more kinds thereof may be mixed and used.

The carboxylic acid generator/sulfonic acid generator (ratio by mass) is usually from 99.9/0.1 to 50/50, preferably from 99/1 to 60/40, more preferably from 98/2 to 70/30.

The carboxylic acid generator can be synthesized by a known method such as the synthesis method described in JP-A-2002-27806.

### [3] Basic compound

In the present invention, a basic compound is preferably used from the standpoint of, for example, enhancing the performance such as resolving power or the storage stability. The basic compound is more preferably a compound containing a nitrogen atom (nitrogen-containing organic basic compound).

The basic compound preferred in the present invention is a compound having basicity stronger than that of phenol.

The preferred chemical environment thereof includes structures of the following formulae (A) to (E). The structures of formulae (B) to (E) each may form a part of a ring structure.

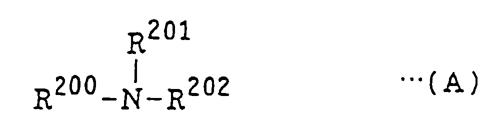

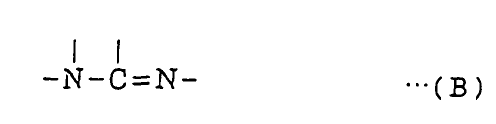

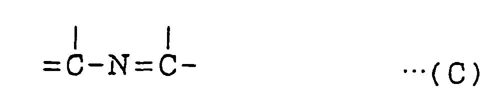

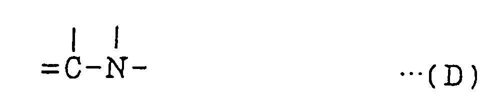

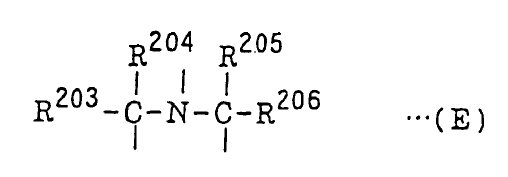

In formula (A), R²⁰⁰, R²⁰¹ and R²⁰², which may be the same or different, each represents a hydrogen atom, an alkyl group or cycloalkyl group having a carbon number of 1 to 20 or an aryl group having a carbon number of 6 to 20, and R²⁰¹ and R²⁰² may combine with each other to form a ring.

The alkyl group, cycloalkyl group and aryl group as R²⁰⁰ , R²⁰¹ and R²⁰² each may have a substituent. The alkyl group or cycloalkyl group having a substituent is preferably an aminoalkyl group or aminocycloalkyl group having a carbon number of 1 to 20 or a hydroxyalkyl group having a carbon number of 1 to 20.

In formula (E), R²⁰³, R²⁰⁴ R²⁰⁵ and R²⁰⁶ which may be the same or different, each represents an alkyl group or cycloalkyl group having a carbon number of 1 to 6.

The compound is more preferably a nitrogen-containing organic basic compound having two or more nitrogen atoms differing in the chemical environment within one molecule, still more preferably a compound containing both a substituted or unsubstituted amino group and a nitrogen-containing ring structure, or a compound having an alkylamino group.

Specific preferred examples thereof include guanidine, aminopyridine, aminoalkylpyridine, aminopyrrolidine, indazole, imidazole, pyrazole, pyrazine, pyrimidine, purine, imidazoline, pyrazoline, piperazine, aminomorpholine and aminoalkylmorpholine. Preferred examples of the substituent which these compounds each may have include an amino group, an alkylamino group, an aminoaryl group, an arylamino group, an alkyl group (as the substituted alkyl group, particularly an aminoalkyl group), an alkoxy group, an acyl group, an acyloxy group, an aryl group, an aryloxy group, a nitro group, a hydroxyl group and a cyano group.

More preferred examples of the compound include, but are not limited to, guanidine, 1,1-dimethylguanidine, 1,1,3,3-tetramethylguanidine, imidazole, 2-methylimidazole, 4-methylimidazole, N-methylimidazole, 2-phenylimidazole, 4,5-diphenylimidazole, 2,4,5-triphenylimidazole, 2-aminopyridine, 3-aminopyridine, 4-aminopyridine, 2-dimethylaminopyridine, 4-dimethylaminopyridine, 2-diethylaminopyridine, 2-(aminomethyl)pyridine, 2-amino-3-methylpyridine, 2-amino-4-methylpyridine, 2-amino-5-methylpyridine, 2-amino-6-methylpyridine, 3-aminoethylpyridine, 4-aminoethylpyridine, 3-aminopyrrolidine, piperazine, N-(2-aminoethyl)piperazine, N-(2-aminoethyl)piperidine, 4-amino-2,2,6,6-tetramethylpiperidine, 4-piperidinopiperidine, 2-iminopiperidine, 1-(2-aminoethyl)pyrrolidine, pyrazole, 3-amino-5-methylpyrazole, 5-amino-3-methyl-1-p-tolylpyrazole, pyrazine, 2-(aminomethyl)-5-methylpyrazine, pyrimidine, 2,4-diaminopyrimidine, 4,6-dihydroxypyrimidine, 2-pyrazoline, . 3-pyrazoline, N-aminomorpholine and N-(2-aminoethyl)morpholine.

One of these nitrogen-containing basic compounds may be used alone, or two or more kinds thereof may be used in combination.

A tetraalkylammonium salt-type nitrogen-containing basic compound may also be used. Among such compounds, a tetraalkylammonium hydroxide having a carbon number of 1 to 8 (e.g., tetramethylammonium hydroxide, tetraethylammonium hydroxide, tetra-(n-butyl)ammonium hydroxide) is preferred. One of these nitrogen-containing basic compounds may be used alone, or two or more kinds thereof may be used in combination.

As for the ratio between the acid generator and the organic basic compound used in the composition, the (total amount of acid generator)/(organic basic compound) (ratio by mol) is preferably from 2.5 to 300. When this molar ratio is 2.5 or more, high sensitivity is obtained, and when the molar ratio is 300 or less, the resist pattern can be prevented from thickening in aging after exposure until heat treatment and the resolving power can be enhanced. The (total amount of acid generator)/(organic basic compound) (ratio by mol) is more preferably from 5.0 to 200, still more preferably from 7.0 to 150.

### [4] (F) Surfactant represented by formula (II)

The positive resist composition of the present invention contains a surfactant represented by the following formula (II).

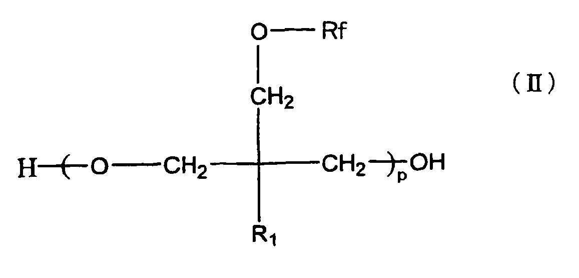

In formula (II), Rf represents a fluoroalkyl group.
R₁ represents a hydrogen atom or an alkyl group.
p represents an integer of 1 to 30.

In formula (II), the fluoroalkyl group of Rf is preferably a fluoroalkyl group having a carbon number of 1 to 10. In the fluoroalkyl group, all hydrogen atoms may be substituted by a fluorine atom, or the hydrogen atoms may be partially substituted by a fluorine atom. The fluoroalkyl group may have an oxy group midway in the alkyl group. Examples of the fluoroalkyl group of Rf include -CF₃, -C₂F₅, - C₃F₇, -C₄F₉, -CH₂CF₃, -CH₂C₂F₅, -CH₂C₃F₇,-CH₂C₄F₉, -CH₂C₆F₁₃, -C₂H₄CF₃, -C₂H₄C₂F₅, -C₂H₄C₄F₉, -C₂H₄C₆F₁₃,-C₂H₄C₈F₁₇, -CH₂CH(CH₃)CF₃, -CH₂CH(CF₃)₂, -CH₂CF(CF₃)₂,-CH₂CH(CF₃)₂, -CF₂CF(CF₃)OCF₃, -CF₂CF(CF₃)OC₃F₇,-C₂H₄OCF₂CF(CF₃)OCF₃, -C₂H₄OCF₂CF(CF₃)OC₃F₇ and -C(CF₃)=C(CF(CF₃)₂)₂.

The alkyl group of R₁ is preferably a linear alkyl group having a carbon number of 1 to 5.

Specific examples of the surfactant represented by formula (II) are set forth below, but the present invention is not limited thereto.

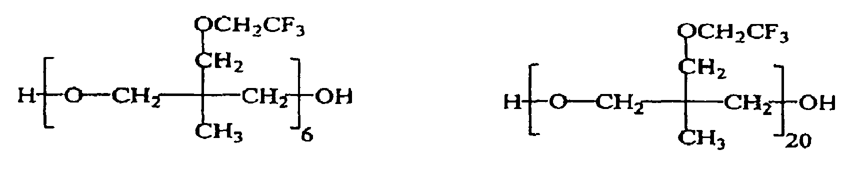

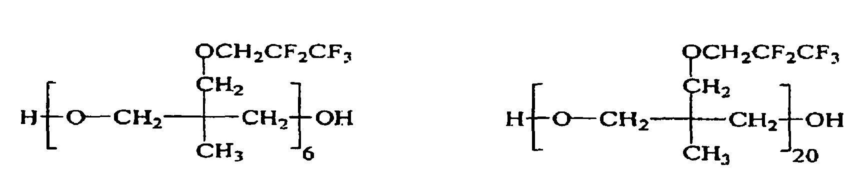

The compounds shown above as specific examples are commercially available from OMNIVA.

The amount added of the surfactant as the component (F) is preferably from 0.01 to 0.7 mass%, more preferably from 0.03 to 0.5 mass% , still more preferably from 0.04 to 0.3 mass%, based on the entire mass of the positive resist composition excluding the solvent.

### [5] Other components

The resist composition of the present invention may further contain, if desired, a dye, a photobase generator and the like.

### 1. Dye

In the present invention, a dye may be used.

The suitable dye includes an oily dye and a basic dye. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industries Co., Ltd.), Crystal Violet (CI42555), Methyl Violet (CI42535), Rhodamine B (CI45170B), Malachite Green (CI42000) and Methylene Blue (CI52015).

### 2. Photobase generator

Examples of the photobase generator which can be added to the composition of the present invention include the compounds described in JP-A-4-151156, JP-A-4-162040, JP-A-5-197148, JP-A-5-5995, JP-A-6-194834, JP-A-8-146608, JP-A-10-83079 and European Patent 622,682. Specific examples of the photobase generator which can be suitably used include 2-nitrobenzyl carbamate, 2,5-dinitrobenzylcyclohexyl carbamate, N-cyclohexyl-4-methylphenylsulfonamide and 1,1-dimethyl-2-phenylethyl-N-isopropyl carbamate. Such a photobase generator is added for the purpose of improving the resist profile or the like.

### 3. Solvents

The resist composition of the present invention is dissolved in a solvent capable of dissolving respective components described above and then coated on a support. The resist composition is usually dissolved to a concentration of, in terms of the solid content concentration of all resist components, preferably from 2 to 30 mass%, more preferably from 3 to 25 mass%.

Preferred examples of the solvent used here include ethylene dichloride, cyclohexanone, cyclopentanone, 2-heptanone, γ-butyrolactone, methyl ethyl ketone, ethylene glycol monomethyl ether, ethylene glycol monoethyl ether, 2-methoxyethyl acetate, ethylene glycol monoethyl ether acetate, propylene glycol monomethyl ether, propylene glycol monomethyl ether acetate, toluene, ethyl acetate, methyl lactate, ethyl lactate, methyl methoxypropionate, ethyl ethoxypropionate, methyl pyruvate, ethyl pyruvate, propyl pyruvate, N,N-dimethylformamide, dimethylsulfoxide, N-methylpyrrolidone and tetrahydrofuran. One of these solvents is used alone, or several kinds thereof are mixed and used.

The resist composition of the present invention is coated on a substrate to form a thin film. The thickness of this coating film is preferably from 0.05 to 4.0 µm.

In the present invention, a commercially available inorganic or organic antireflection film may be used, if desired. Furthermore, the antireflection film may be used by coating it as an underlayer of the resist.

The antireflection film used as the underlayer of the resist may be either an inorganic film type such as titanium, titanium dioxide, titanium nitride, chromium oxide, carbon and amorphous silicon, or an organic film type comprising a light absorbent and a polymer material. The former requires equipment for the film formation, such as vacuum deposition apparatus, CVD apparatus and sputtering apparatus. Examples of the organic antireflection film include a film comprising a diphenylamine derivative/formaldehyde-modified melamine resin condensate, an alkali-soluble resin and a light absorbent described in JP-B-7-69611, a reaction product of a maleic anhydride copolymer and a diamine-type light absorbent described in U.S. Patent 5,294,680, a film containing a resin binder and a methylolmelamine-based heat crosslinking agent described in JP-A-6-118631, an acrylic resin-type antireflection film containing a carboxylic acid group, an epoxy group and a light absorbing group within the same molecule described in JP-A-6-118656, a film comprising a methylolmelamine and a benzophenone-based light absorbent described in JP-A-8-87115, and a film obtained by adding a low molecular light absorbent to a polyvinyl alcohol resin described in JP-A-8-179509.

Also, the organic antireflection film may be a commercially available organic antireflection film such as DUV-30 Series and DUV-40 Series produced by Brewer Science, Inc., or AR-2, AR-3 and AR-5 produced by Shipley Co., Ltd.

In the production or the like of a precision integrated circuit device, the step of forming a pattern on a resist film is performed by coating the resist composition of the present invention on a substrate (for example, a silicon/silicon dioxide-coated substrate, a glass substrate, an ITO substrate or a quartz/chromium oxide-coated substrate) to form a resist film, irradiating thereon an actinic ray or radiation such as KrF excimer laser light, electron beam or EUV light, and then subjecting the resist film to heating, development, rinsing and drying, whereby a good resist pattern can be formed.

The alkali developer which can be used in the development is an aqueous solution of alkalis (usually from 0.1 to 20 mass%) such as inorganic alkalis (e.g., sodium hydroxide, potassium hydroxide, sodium carbonate, sodium silicate, sodium metasilicate, aqueous ammonia), primary amines (e.g., ethylamine, n-propylamine), secondary amines (e.g., diethylamine, di-n-butylamine), tertiary amines (e.g., triethylamine, methyldiethylamine), alcohol amines (e.g., dimetylethanolamine, triethanolamine), quaternary ammonium salts (e.g., tetramethylammonium hydroxide, tetraethylammonium hydroxide, choline) and cyclic amines (e.g., pyrrole, piperidine). This aqueous solution of alkalis may be used after adding thereto an appropriate amount of alcohols such as isopropyl alcohol or a surfactant such as nonionic surfactant.

Among these developers, a quaternary ammonium salt is preferred, and tetramethylammonium hydroxide and choline are more preferred.

The pH of the alkali developer is usually from 10 to 15.

### [Examples]

The present invention is described in greater detail below by referring to Examples, but the present invention should not be construed as being limited thereto.

### Synthesis Example 1 (synthesis of Resin (A-2)):

Acetoxystyrene, styrene and 1-phenylethyl methacrylate were charged at a ratio of 60/15/25 (by mol) and dissolved in tetrahydrofuran to prepare 100 mL of a solution having a solid content concentration of 20 mass%. Subsequently, 2 mol% of a polymerization initiator, V-65, produced by Wako Pure Chemical Industries, Ltd. was added thereto and the resulting solution was added dropwise to 10 ml of tetrahydrofuran heated at 60°C, over 4 hours in a nitrogen atmosphere. After the completion of dropwise addition, the reaction solution was heated for 4 hours, and 1 mol% of V-65 was again added, followed by stirring for 4 hours. After the completion of reaction, the reaction solution was cooled to room temperature and then crystallized in 3 L of hexane, and the precipitated white powder was collected by filtration.

The compositional ratio of the polymer determined from C¹³NMR was 58/16/26 (by mol). Also, the weight average molecular weight determined by GPC was 9,500 in terms of standard polystyrene.

This polymer was dissolved in 100 ml of acetone, 5 ml of hydrochloric acid was then added thereto and after stirring 1 hour, distilled water was added to precipitate the polymer. The precipitate was washed with distilled water and dried under reduced pressure. Furthermore, the polymer was dissolved in 100 ml of ethyl acetate and after adding hexane, the polymer precipitated was dried under reduced pressure to obtain Resin (A-2) in a powder form. The weight average molecular weight of Resin (A-2) determined by GPC was 10,000 in terms of the standard polystyrene.

Resins (A-1)-1, (A-1)-2, (A-1)-3, (A-1)-4, (A-1)-5, (A-3), (A-4), (A-37), (A-9), (A-12), (A-15), (A-16), (A-20), (A-21), (A-22), (A-26), (A-31), (A-33), (A-36) and (A-40), which are the resin as the component (A), were synthesized in the same manner as in Synthesis Example 1.

Resins (A-1)-1 to (A-1)-5 all had the structure of the specific example (A-1) above, and Resin (A-3) had the structure of the specific example (A-3) above (hereinafter the same).

The repeating units (mol%), weight average molecular weight (Mw) and dispersity of each ofResins (A-1)-1, (A-1)-2, (A-1)-3, (A-1)-4, (A-1)-5, (A-3), (A-4), (A-37), (A-9), (A-12), (A-15), (A-16), (A-20), (A-21), (A-22), (A-26), (A-31), (A-33), (A-36), (A-40) and (A-2) are shown in Table 1 below. Respective repeating units (mol%) are starting from the left in each structural formula.

**Table 1**

| Resin | Repeating Unit (mol%) | Mw/Dispersity |
|---|---|---|
| (A-1)-1 | 45/55 | 7800/1.76 |
| (A-1)-2 | 55/45 | 7500/1.83 |
| (A-1)-3 | 60/40 | 7500/1.73 |
| (A-1)-4 | 80/20 | 7600/1.69 |
| (A-1)-5 | 95/5 | 7600/1.81 |
| (A-3) | 80/20 | 8700/1.65 |
| (A-4) | 65/15/20 | 8500/1.74 |
| (A-37) | 65/1S/20 | 9200/1.81 |
| (A-9) | 70/10/20 | 8000/1.80 |
| (A-12) | 60/15/25 | 10200/1.78 |
| (A-15) | 70/10/20 | 8300/1.93 |
| (A-16) | 70/10/20 | 9000/1.81 |
| (A-20) | 65/35 | 8800/1.84 |
| (A-21) | 80/20 | 9800/1.77 |
| (A-22) | 70/30 | 10500/1.75 |
| (A-26) | 80/20 | 7200/1.69 |
| (A-31) | 80/20 | 6800/1.80 |
| (A-33) | 85/15 | 7400/1.78 |
| (A-36) | 75/10/15 | 8300/1.68 |
| (A-40) | 60/15/25 | 10000/1.78 |
| (A-2) | 60/15/25 | 10000/1.74 |

### Examples 1 to 27 and Comparative Examples 1 to 5:

The components shown in Table 2 below were dissolved in 8.8 g of propylene glycol monomethyl ether acetate, and the obtained uniform solution was microfiltered through a membrane filter having a pore size of 0,1 µm to prepare a positive resist solution.

This positive resist solution was coated on a 8-inch silicon wafer by using a spin coater, ACT 8, manufactured by Tokyo Electron Ltd. and then baked at 130°C for 60 seconds to obtain a resist film having an average thickness of 420 nm. The obtained resist film was then subjected to pattern exposure using a KrF excimer laser scanner (PAS5500/850C, manufactured by ASML, wavelength: 248 nm, NA: 0.75, sigma: 0.80). After the irradiation, the resist film was baked at 130°C for 60 seconds, dipped in an aqueous 2.38 mass% tetramethylammonium hydroxide (TMAH) solution for 60 seconds, rinsed with water for 30 seconds and dried.

The line width of the obtained pattern was observed by a scanning electron microscope (S-9260, manufactured by Hitachi, Ltd.), and the irradiation energy sensitivity when reproducing a 0.20-µm line (line:space = 1:1) was determined.

The wafer was again treated in the same manner with this sensitivity, and a pattern of 0.20 µm was exposed at 78 portions in the wafer plane. At this time, the area of exposure was 205 cm² in total. The number of development defects in the obtained wafer with a pattern was measured by KLA-2360 manufactured by KLA Tencol Co., Ltd., and the value obtained by dividing the measured numerical value by the area of exposure was defined as the number of development defects (defects/cm²).

When the number of development defects is 1 or more, this is in the NG level. The improvement level is a value of 1 or less, and the improvement level increases in the order of a value from 0.8 to less than 1, a value from 0.6 to less than 0.8, a value from 0.4 to less than 0.6, and a value from 0.2 to less than 0.4.

The results are shown in Table 2.

**Table 2**

| | Resin (0.93 g) | Acid Generator (0.02 g) | Basic Compound (0.002 g) | Surfactant, g (mass%) | Number of Development Defects (defects/cm²) |
|---|---|---|---|---|---|
| Example 1 | (A-1)-4 | B-2 | D-2 | W-2, 0.0001 g (0.01 mass%) | 0.97 |
| Example 2 | (A-1)-4 | B-2 | D-2 | W-2, 0.0003 g (0.03 mass%) | 0.72 |
| Example 3 | (A-1)-4 | B-2 | D-2 | W-2, 0.0005 g (0.05 mass%) | 0.51 |
| Example 4 | (A-1)-4 | B-2 | D-2 | W-2, 0.003 g (0.31 mass%) | 0.59 |
| Example 5 | (A-1)-4 | B-2 | D-2 | W-2, 0.004 g (0.41 mass%) | 0.63 |
| Example 6 | (A-1)-4 | B-2 | D-2 | W-2, 0.006 g (0.63 mass%) | 0.83 |
| Example 7 | (A-1)-4 | B-2 | D-2 | W-2, 0.01 g (1.04 mass%) | 1.12 |
| Example 8 | (A-1)-1 | B-2 | D-2 | W-2, 0.0005 g (0.05 mass%) | 0.96 |
| Example 9 | (A-1)-2 | B-2 | D-2 | W-2, 0.0005 g (0.05 mass%) | 0.73 |
| Example 10 | (A-1)-3 | B-2 | D-2 | W-2, 0.0005 g (0.05 mass%) | 0.50 |
| Example 11 | (A-1)-5 | B-2 | D-1 | W-2, 0.0005 g (0.05 mass%) | 0.95 |
| Example 12 | (A-3) | B-8 | D-2 | W-1, 0.0005 g (0.05 mass%) | 0.49 |
| Example 13 | (A-4) | B-6 | D-3 | W-3, 0.0005 g (0.05 mass%) | 0.55 |
| Example 14 | (A-37) | B-4 | D-2 | W-4, 0.0005 g (0.05 mass%) | 0.59 |
| Example 15 | (A-9) | B-2 | D-2 | W-2. 0.0005 g (0.05 mass%) | 0.35 |
| Example 16 | (A-12) | B-2 | D-2 | W-1, 0.0005 g (0.05 mass%) | 0.25 |
| Example 17 | (A-15) | B-2 | D-2 | W-4, 0.0005 g (0.05 mass%) | 0.31 |
| Example 18 | (A-16) | B-2 | D-2 | W-3, 0.0005 g (0.05 mass%) | 0.37 |
| Example 19 | (A-20) | B-16 | D-2 | W-2, 0.0005 g (0.05 mass%) | 0.48 |
| Example 20 | (A-21) | B-17 | D-2 | W-4, 0.0005 g (0.05 mass%) | 0.45 |
| Example 21 | (A-22) | B-22 | D-2 | W-3, 0.0005 g (0.05 mass%) | 0.43 |
| Example 22 | (A-26) | B-41 | D-2 | W-1, 0.0005 g (0.05 mass%) | 0.54 |
| Example 23 | (A-31) | B-49 | D-2 | W-2, 0.0005 g (0.05 mass%) | 0.48 |
| Example 24 | (A-33) | B-2 | D-2 | W-3, 0.0005 g (0.05 mass%) | 0.52 |
| Example 25 | (A-36) | B-2 | D-2 | W-4, 0.0005 g (0.05 mass%) | 0.57 |
| Example 26 | (A-40) | B-2 | D-2 | W-2, 0.0005 g (0.05 mass%) | 0.27 |
| Example 27 | (A-2) | B-2 | D-2 | W-2, 0.0005 g (0.05 mass%) | 0.54 |
| Comparative Example 1 | (A-1)-4 | B-2 | D-2 | W-5, 0.005 g (0.52 mass%) | 1.43 |
| Comparative Example 2 | (A-1)-4 | B-2 | D-2 | W-6, 0.005 g (0.52 mass%) | 1.62 |
| Comparative Example 3 | (A1)-4 | B-2 | D-2 | not added | 1.31 |
| Comparative example 4 | C-1 | B-2 | D-2 | not added | 1.95 |
| Comparative Example 5 | C-2 | B-2 | D-2 | not added | 1.87 |

The abbreviations in the Table indicate the followings.

### [Resin]

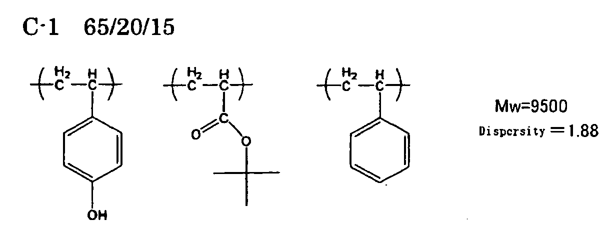

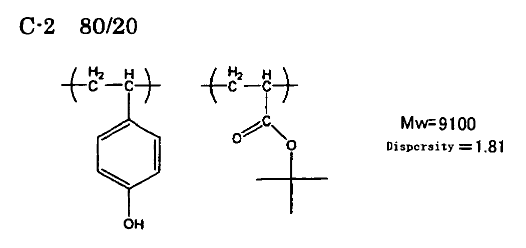

### [Basic Compound]

D-1: Tri-N-hexylamine
D-2: 2,4,6-Triphenylimidazole
D-3: Tetra-(n-butyl)ammonium hydroxide

### [Surfactant]

W-1: PF636 (produced by OMNOVA) (fluorine-containing)
W-2: PF6320 (produced by OMNOVA) (fluorine-containing)
W-3: PF656 (produced by OMNOVA) (fluorine-containing)
W-4: PF6520 (produced by OMNOVA) (fluorine-containing)
W-5: Megafac R08 (produced by Dainippon Ink & Chemicals, Inc.) (fluorine/silicon-containing)
W-6: Florad FC430 (produced by Sumitomo 3M Inc.) (fluorine-containing)

The structures of PF636, PF6320, PF656 and PF6520 are shown below.

| | |
|---|---|
| PF636 | 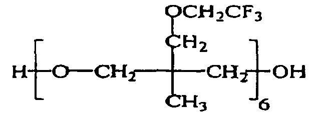 |
| PF6320 | 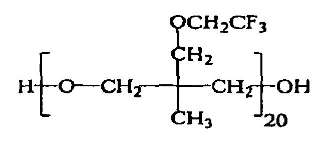 |
| PF656 | 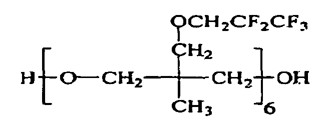 |
| PF6520 | 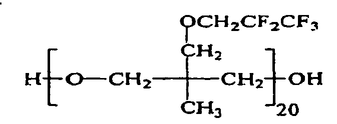 |

As apparent from Table 2, the positive resist composition of the present invention has excellent performance against development defects.

According to the present invention, a positive resist composition improved in the performance against development defects at the fine processing of a semiconductor device using an actinic ray or radiation, particularly, KrF excimer laser light, electron beam or EUV light, and a pattern forming method using the same can be provided.

The entire disclosure of each and every foreign patent application from which the benefit of foreign priority has been claimed in the present application is incorporated herein by reference, as if fully set forth.

## Claims

1. A positive resist composition comprising:
(A) a resin having a repeating unit represented by formula (I) and a repeating unit represented by formula (A1);
(B) a compound capable of generating an acid upon irradiation with an actinic ray or radiation; and
(F) a surfactant represented by formula (II): 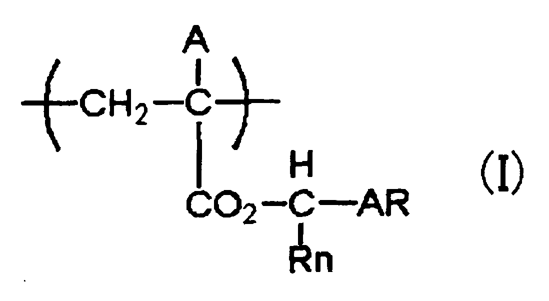 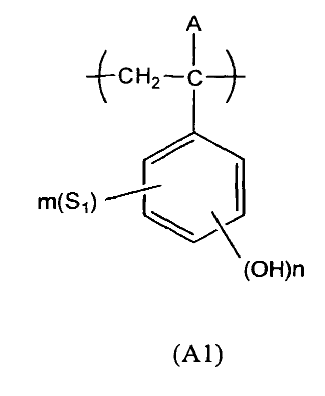
wherein A represents a hydrogen atom, an alkyl group, a halogen atom, a cyano group or an alkyloxycarbonyl group,
AR represents a benzene ring or a naphthalene ring,
Rn represents an alkyl group, a cycloalkyl group or an aryl group,
S₁ represents a substituent, and when a plurality of S₁s are present, S₁s each independently represents a substituent,
m represents an integer of 0 to 3, and
n represents an integer of 0 to 3, provided that m+n≤5; 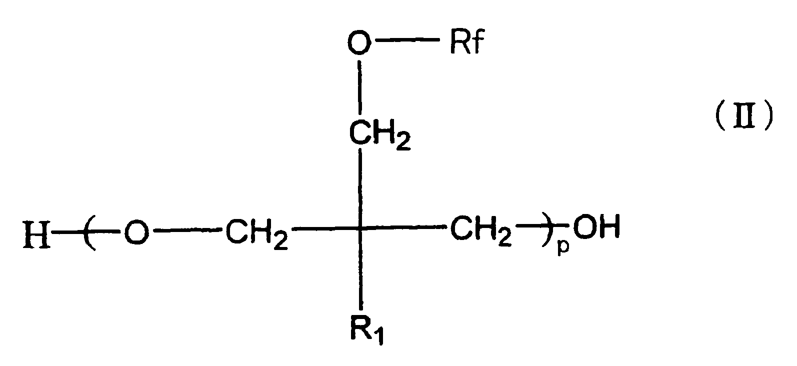 wherein Rf represents a fluoroalkyl group,
R₁ represents a hydrogen atom or an alkyl group, and
p represents an integer of 1 to 30.

2. The positive resist composition as claimed in claim 1,
wherein the repeating unit represented by formula (A1) is at least one kind of a repeating unit selected from the group consisting of a repeating unit represented by formula (A1-1) and a repeating unit represented by formula (A1-2): 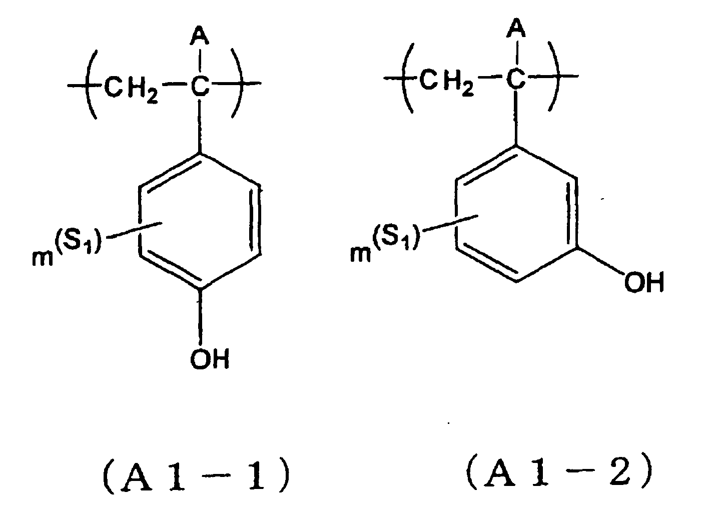 wherein A represents a hydrogen atom, an alkyl group, a halogen atom, a cyano group or an alkyloxycarbonyl group,
S₁ represents a substituent, and when a plurality of S₁s are present, S₁S each independently represents a substituent, and
m represents an integer of 0 to 3.

3. The positive resist composition as claimed in claim 1,
wherein an amount of the surfactant (F) is from 0.01 to 0.7 mass% based on the entire mass of the positive resist composition excluding the solvent.

4. The positive resist composition as claimed in claim 1,
wherein the resin (A) further has a repeating unit represented by formula (A2): 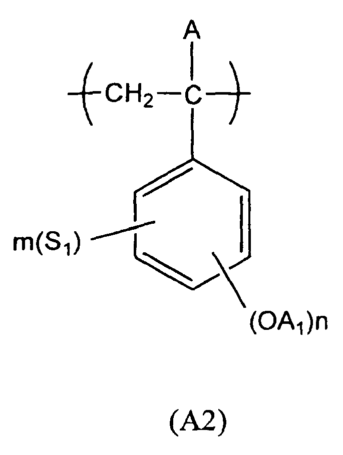 wherein A represents a hydrogen atom, an alkyl group, a halogen atom, a cyano group or an alkyloxycarbonyl group,
S₁ represents a substituent, and when a plurality of S₁s are present, S₁s each independently represents a substituent,
A₁ represents a group which desorbs under an action of an acid, or a group having an acid-decomposable group,
m represents an integer of 0 to 3, and
n represents an integer of 0 to 3, provided that m+n≤5.

5. A pattern forming method comprising:
forming a resist film with the positive resist composition claimed in claim 1; and
exposing and developing the resist film.
